# EUROPEAN PATENT APPLICATION

(11) **EP 4 261 876 A1**
(43) Date of publication of application: **18.10.2023**
(21) Application number: 21903490.7
(22) Date of filing: 10.12.2021
(51) Int. Cl.: H01L 23/12, H01L 23/14, H05K 1/14, H05K 3/00, H05K 3/36, H05K 3/46

(54) **SUBSTRATE UNIT WITH SUPPORT, SUBSTRATE UNIT, AND METHOD FOR MANUFACTURING SUBSTRATE UNIT WITH SUPPORT**

(30) Priority: 10.12.2020 JP 2020205343; 09.02.2021 JP 2021019033; 10.02.2021 JP 2021019784
(71) Applicant: TOPPAN INC., Tokyo 110-0016 (JP)
(72) Inventor: KIZU, Takashi, Tokyo 110-0016 (JP); KOBAYASHI, Akane, Tokyo 110-0016 (JP); NITTA, Yuki, Tokyo 110-0016 (JP)
(74) Representative: Plasseraud IP
(86) International application number: PCT/JP2021/045515
(87) International publication number: WO 2022/124394

(57) **Abstract**

There are provided a board unit with support which does not require a high-energy UV laser and which is less likely to form residues of the release layer after separation of the support, a board unit, and a semiconductor device, and a method of producing them. The board unit with support includes a support, a release layer, a laser absorption layer that absorbs laser light, and at least one first wiring board in this order, wherein the at least one first wiring board has a first surface provided with first electrodes that can be bonded to at least one semiconductor element, the at least one first wiring board has a second surface provided with second electrodes that can be bonded to a second wiring board.

## Description

### [Technical Field]

The present invention relates to board units with support, board units, and methods of producing board units with support.

### [Background Art]

In recent years, as semiconductor devices become faster and more highly integrated, FC-BGA (flip chip-ball grid array) boards are required to have narrower-pitch junction terminals to semiconductor elements and to miniaturize board wiring. However, for junctions to motherboards, FC-BGA boards are required to have junction terminals with pitches that are substantially unchanged from the conventional art. To cope with such a need for narrower pitch junction terminals to semiconductor elements, and for miniaturization of the wiring in the FC-BGA boards, some countermeasures are being considered. One of them is a method in which a board provided with fine wiring for bonding semiconductor elements thereto (silicon interposer) is formed on a silicon substrate, and this is bonded to an FC-BGA board. PTL 1 discloses a method in which the surface of an FC-BGA board is flattened using chemical mechanical polishing (CMP) or the like, and fine wiring is formed on the FC-BGA board without using a silicon interposer. PTL 2 discloses a method of forming a narrow pitch wiring board by forming a fine wiring layer on a support, disposing this on an FC-BGA board, and then separating the support.

### [Citation List]

### [Patent Literature]

PTL 1: JP 2014-225671 A
PTL 2: WO2018/047861

### [Summary of the Invention]

### [Technical Problem]

Silicon interposers are prepared using silicon wafers and using preprocessing equipment for the manufacture of semiconductors. Silicon wafers are limited in shape and size and the number of interposers that can be prepared from one wafer is small. In addition, since manufacturing equipment is expensive, interposers also become expensive. Also, there is an issue that silicon wafers, which are made of semiconductor materials, tend to deteriorate in transmission characteristics.

The method of forming a fine wiring layer on an FC-BGA board after flattening the surface thereof suffers from an issue that the productivity of the FC-BGA boards is low, although deterioration in transmission characteristics that can be seen in silicon interposers is small, and also suffers from an issue that the manufacturing yield of the fine wiring is low due to high difficulty of forming fine wiring on the FC-BGA boards. Also, there are issues related to mounting of semiconductor elements due to warpage and strain of FC-BGA boards.

On the other hand, the method in which a fine wiring layer is formed on a support, and this is disposed on an FC-BGA board or integrated with semiconductor elements, followed by separating the support, has suffered from the following issues.

In the method in which the support is separated, a release layer is provided on the surface of the support in advance, and the support is separated by irradiating the release layer with a laser. Since this separation requires high-energy UV laser irradiation, a high-power laser device is required to be used or laser irradiation is required to be repeated, which raises an issue of placing a large load on the processing. Also, since the release layer is required to be removed after separation of the support, an altered layer tends to be formed induced by laser irradiation, which raises an issue that residues tend to be formed on the surface of the wiring board.

The present invention has been made in light of the above issues and aims to provide a board unit with support which does not require a high-energy UV laser and which is less likely to form residues of the release layer after separation of the support, and to provide a board unit and a semiconductor device, and a method of producing them.

### [Solution to Problem]

In order to solve the above issues, an aspect of the present invention is a board unit with support including a support, a release layer, a laser absorption layer that absorbs laser light, and at least one first wiring board in this order, wherein the at least one first wiring board has a first surface provided with first electrodes that can be bonded to at least one semiconductor element, the at least one first wiring board has a second surface provided with second electrodes that can be bonded to a second wiring board.

Another aspect of the present invention is a board unit produced using the board unit with support, wherein the at least one wiring board has a second surface to which a second wiring board is bonded; and the support is absent due to removal by laser irradiation.

Still another aspect of the present invention is a method of producing a board unit with support, including steps of forming a release layer and a laser absorption layer in this order on an upper surface of a support; forming a seed layer on the laser absorption layer; forming electrodes on the seed layer using an electroplating layer; obtaining multilayer wiring by repeating formation of a resin layer and a conductor layer on upper surfaces of the electrodes; and preparing at least one first wiring board by forming electrodes on an uppermost surface of the multilayer wiring.

### [Advantageous Effects of the Invention]

According to the present invention, there can be provided a board unit with support which does not require a high-energy UV laser and which is less likely to form residues of the release layer after separation of the support, a board unit, and a method of producing the board unit with support.

Issues and advantageous effects other than those described above will be described in the following embodiments of the invention.

### [Brief Description of the Drawings]

Fig. 1 is a cross-sectional view illustrating an example of a semiconductor device, according to an embodiment of the present invention.
Fig. 2 is a cross-sectional view illustrating a configuration of a board unit with support, according to one embodiment of the present invention.
Fig. 3 is a set of diagrams illustrating a state in which a release layer and a laser absorption layer are formed on the upper surface of a support.
Fig. 4 is a plan view illustrating a state in which a plurality of second wiring boards are disposed on the support.
Fig. 5A is a set of cross-sectional views illustrating an example of a process of producing a board unit with support, according to an embodiment of the present invention.
Fig. 5B is a set of cross-sectional views illustrating an example of a process of producing a board unit with support, according to an embodiment of the present invention.
Fig. 5C is a set of cross-sectional views illustrating an example of a process of producing a board unit with support, according to an embodiment of the present invention.
Fig. 6A is a cross-sectional view illustrating an example of a method of producing a board unit, according to an embodiment of the present invention.
Fig. 6B is a cross-sectional view illustrating an example of a method of producing a board unit, according to an embodiment of the present invention.
Fig. 6C is a cross-sectional view illustrating an example of a method of producing a board unit, according to an embodiment of the present invention.
Fig. 6D is a cross-sectional view illustrating an example of a method of producing a board unit, according to an embodiment of the present invention.
Fig. 6E is a cross-sectional view illustrating an example of a method of producing a board unit, according to an embodiment of the present invention.
Fig. 7A is a set of cross-sectional views illustrating an example of a method of producing a semiconductor device, according to an embodiment of the present invention.
Fig. 7B is a set of cross-sectional views illustrating an example of a method of producing a semiconductor device, according to an embodiment of the present invention.
Fig. 8 is a cross-sectional view illustrating an example of a semiconductor device, according to an embodiment of the present invention.
Fig. 9 is a schematic cross-sectional view illustrating a wiring board with support, according to an embodiment of the present invention.
Fig. 10 is a schematic cross-sectional view illustrating a support in a method of producing a wiring board with support, according to an embodiment of the present invention.
Fig. 11 is a schematic cross-sectional view illustrating a process of forming a light absorption layer and a release layer in a method of producing a wiring board with support, according to an embodiment of the present invention.
Fig. 12 is a schematic cross-sectional view illustrating a process of forming a first seed layer in a method of producing a wiring board with support, according to an embodiment of the present invention.
Fig. 13 is a schematic cross-sectional view illustrating a process of forming a resist layer in a method of producing a wiring board with support, according to an embodiment of the present invention.
Fig. 14 is a schematic cross-sectional view illustrating a process of forming a conductor layer in a method of producing a wiring board with support, according to an embodiment of the present invention.
Fig. 15 is a schematic cross-sectional view illustrating a process of forming an insulating layer in a method of producing a wiring board with support, according to an embodiment of the present invention.
Fig. 16 is a schematic cross-sectional view illustrating a process of forming openings in an insulating layer in a method of producing a wiring board with support, according to an embodiment of the present invention.
Fig. 17 is a schematic cross-sectional view illustrating a process of forming a second seed layer in a method of producing a wiring board with support, according to an embodiment of the present invention.
Fig. 18 is a schematic cross-sectional view illustrating a process of forming a resist layer and a conductor layer in a method of producing a wiring board with support, according to an embodiment of the present invention.
Fig. 19 is a schematic cross-sectional view illustrating a process of removing a resist layer in a method of producing a wiring board with support, according to an embodiment of the present invention.
Fig. 20 is a schematic cross-sectional view illustrating a process of forming a conductor layer, an insulating layer, and a second seed layer in a method of producing a wiring board with support, according to an embodiment of the present invention.
Fig. 21 is a schematic cross-sectional view illustrating a process of forming an outermost surface insulating layer in a method of producing a wiring board with support, according to an embodiment of the present invention.
Fig. 22 is a schematic cross-sectional view illustrating a process of forming a surface treatment layer in a method of producing a wiring board with support, according to an embodiment of the present invention.
Fig. 23 is a schematic cross-sectional view illustrating a process of forming first metal bumps in a method of producing a wiring board with support, according to an embodiment of the present invention.
Fig. 24 is a schematic cross-sectional view illustrating a wiring board with support as a result of omitting the wiring board, the outermost surface insulating layer, the surface treatment layer, and the first metal bumps.
Fig. 25 is a schematic plan view illustrating a release layer-side surface of the wiring board with support illustrated in Fig. 24.
Fig. 26 is a schematic plan view illustrating wiring boards with support each omitting the outermost surface insulating layer, the surface treatment layer, and the first metal bumps.
Fig. 27 is a schematic cross-sectional view illustrating a first wiring board in a method of producing a composite wiring board, according to an embodiment of the present invention.
Fig. 28 is a schematic cross-sectional view illustrating a process of aligning a first wiring board and a wiring board with support in a method of producing a composite wiring board, according to an embodiment of the present invention.
Fig. 29 is a schematic cross-sectional view illustrating a process of bonding a first wiring board and a wiring board with support together in a method of producing a composite wiring board, according to an embodiment of the present invention.
Fig. 30 is a schematic cross-sectional view illustrating a process of laser light irradiation in a method of producing a composite wiring board, according to an embodiment of the present invention.
Fig. 31 is a schematic cross-sectional view illustrating a process of separating a support in a method of producing a composite wiring board, according to an embodiment of the present invention.
Fig. 32 is a schematic cross-sectional view illustrating a composite wiring board, according to an embodiment of the present invention.
Fig. 33 is a schematic cross-sectional view illustrating a packaged device, according to an embodiment of the present invention.
Fig. 34 is a schematic cross-sectional view illustrating a process of bonding a wiring board with support and functional devices together in a method of producing a functional device-equipped wiring board, according to an embodiment of the present invention.
Fig. 35 is a schematic cross-sectional view illustrating a process of forming a second underfill in a method of producing a functional device-equipped wiring board, according to an embodiment of the present invention.
Fig. 36 is a schematic cross-sectional view illustrating a process of forming a sealing resin in a method of producing a functional device-equipped wiring board, according to an embodiment of the present invention.
Fig. 37 is a schematic cross-sectional view illustrating a process of laser light irradiation in a method of producing a functional device-equipped wiring board, according to an embodiment of the present invention.
Fig. 38 is a schematic cross-sectional view illustrating a process of separating a support in a method of producing a functional device-equipped wiring board, according to an embodiment of the present invention.
Fig. 39 is a schematic cross-sectional view illustrating a functional device-equipped wiring board, according to an embodiment of the present invention.
Fig. 40 is a diagram illustrating a state in which a release layer and a first wiring board are formed on the upper surface of a support, and a warp-suppression layer is formed on the lower surface of the support.
Fig. 41 is a plan view illustrating a state in which a plurality of first wiring boards are disposed on a support.
Fig. 42 is a set of cross-sectional views illustrating a state in which a release layer and an insulating resin layer are formed on the upper surface of a support, and a warp-suppression layer is formed on the lower surface of the support.
Fig. 43 is a set of cross-sectional views illustrating a process of forming an insulating resin layer and a conductor layer.
Fig. 44A is a set of cross-sectional views illustrating a process of forming a conductor layer after forming insulating resin layer portions in vias.
Fig. 44B is a set of cross-sectional views illustrating a process of removing a resist pattern and etching away unnecessary seed layer portions.
Fig. 45 is a cross-sectional view illustrating a state in which multilayer wiring is formed.
Fig. 46 is a cross-sectional view illustrating a state in which electrodes for bonding to semiconductor elements are formed.
Fig. 47 is a cross-sectional view illustrating a state in which a surface treatment layer is formed, and a first wiring board on a support is completed.
Fig. 48 is a set of cross-sectional views illustrating a process of mounting semiconductor elements to a first wiring board.
Fig. 49 is a set of cross-sectional views illustrating a process of removing a release layer.
Fig. 50 is a process diagram illustrating formation of solder joints on a first wiring board.
Fig. 51 is a cross-sectional view illustrating a state in which a first wiring board to which semiconductor elements are mounted is disposed on an FC-BGA board.
Fig. 52 is a cross-sectional view illustrating an example of a semiconductor device according to the present invention.
Fig. 53 is a cross-sectional view illustrating an example of a comparative example.

### [Description of the Embodiments]

With reference to the drawings, some embodiments of the present invention will be described below. In the following description of the drawings, components identical with or similar to each other are given the same or similar reference signs. It should be noted, however, the drawings are only schematically illustrated, and thus the relationship between thicknesses and planar dimensions of the components, the thickness ratio between the layers, and the like are not to scale. Accordingly, specific thicknesses or dimensions should be understood referring to the following description. As a matter of course, dimensional relationships or ratios may be different between the drawings.

The embodiments described below only exemplify devices or methods embodying the technical idea of the present invention. The technical idea of the present invention should not limit the materials, shapes, structures, layouts, and the like of the components to those described below. The technical idea of the present invention can be modified in various ways within the technical scope defined in the claims.

In the present disclosure, the term "support" refers to an object having surfaces.

The term "upper surface" refers to a normal direction front surface of a layer, and the term "lower surface" refers to a normal direction rear surface of a layer.

The term "upper" refers to the vertically upward direction when a surface or a layer is horizontally placed.

The term "lower" refers to the vertically downward direction when a surface or a layer is horizontally placed.

The term "planar shape" or "in plan view" refers to a shape when a surface or a layer is seen perpendicularly.

### <First Embodiment>

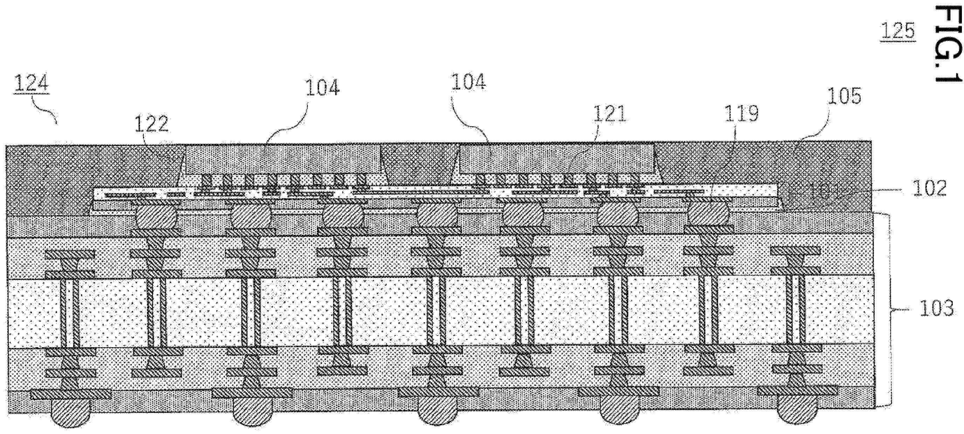

Fig. 1 is a cross-sectional view illustrating an example of a semiconductor device according to an embodiment of the present invention. In the present embodiment, a first wiring board is an interposer, and a second wiring board is an FC-BGA board.

In a semiconductor device 125 according to an embodiment of the present invention, a thin first wiring board (which may be termed "interposer" hereinafter) 1 provided with a fine wiring layer formed of only a built-up wiring layer, in which resins and wiring are laminated with each other, is disposed on one surface of a second wiring board (which may be termed "FC-BGA board" hereinafter) 3. The first wiring board 101 and the second wiring board 103 are bonded together via junction electrodes, such as solder bumps, copper posts (copper pillars), gold pumps, or the like. These joints will be referred to as interposer-FC-BGA joints 119. The gap between the first and second wiring boards 101 and 103 is filled with an underfill 102 as an insulating adhesive material. In the first wiring board 101, the surface to which semiconductor elements 104 are bonded via copper pillars or solder (the surface facing away from the surface provided with the second wiring board 103) is referred to as a first surface, and portions to which the semiconductor elements 104 are bonded are referred to as semiconductor element-interposer joints 121. The gap between each semiconductor element 104 and the first wiring board 101 is filled with an underfill 122.

The wiring width in the first wiring board (interposer) 1 may be line/space=1/1 µm to 5/5 µm, as an example, and the wire width in the first wiring board (FC-BGA board) 1 may be line/space=8/8 µm to 25/25 µm, as an example. The wiring width in the first wiring board (interposer) 1 may be changed as appropriate as long as the wiring can be connected to the signal lines of one or more mounted semiconductor elements 104.

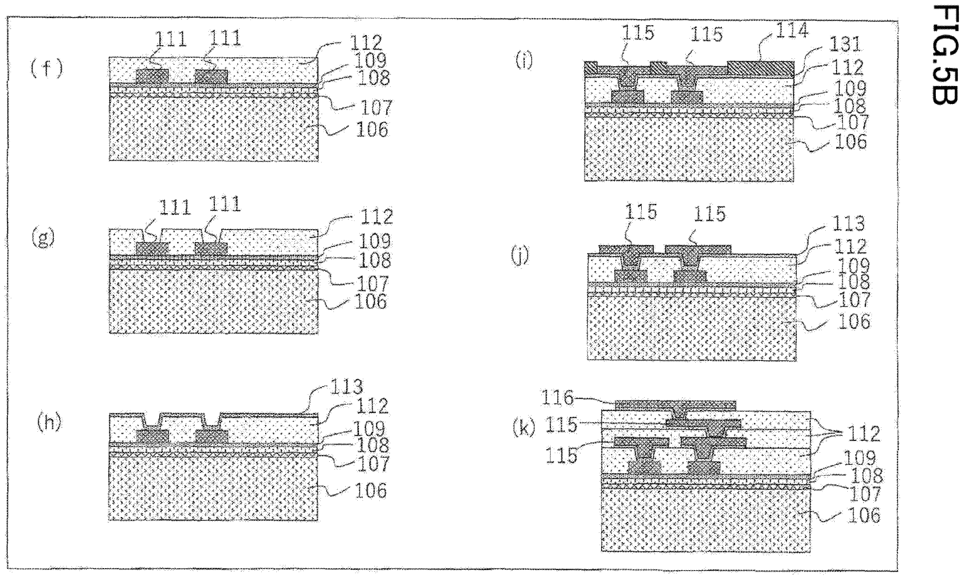

The first wiring board (interposer) 1 includes an insulating resin layer 112 (see Fig. 5B) made of photosensitive resins containing one or more of a photosensitive epoxy resin, polyimide resin, and polyamide resin. If a desired wiring width can be obtained, the wiring forming method may be appropriately selected from a damascene process, semi additive process (SAP), and the like.

The underfill 102 is an adhesive material used for fixing the first and second wiring boards 101 and 103 and sealing the interposer-FC-BGA joints 119. The material used for the underfill 102 may be, for example, a material obtained by adding silica, titanium oxide, aluminum oxide, magnesium oxide, zinc oxide, etc. as a filler, to one of an epoxy resin, urethane resin, silicone resin, polyester resin, oxetane resin, and maleimide resin, or a mixture of two or more of these resins. The underfill 102 may be formed by filling with a liquid resin.

The underfill 122 is an adhesive material used for fixing the semiconductor elements 104 and the first wiring board 101 and sealing the semiconductor element-interposer joints 121, and is made of the same material as that of the underfill 102. Instead of filling the gaps with the underfill 101 and/or the underfill 102 making use of the capillary action after bonding, an anisotropically conductive film (ACF) or a non-conductive film (NCF), i.e., a sheet-like film, may be disposed in each space in advance before bonding to thereby fill the space when bonding, or a non-conductive paste (NCP) or the like, i.e., a liquid-form resin, may be disposed in each space in advance before bonding to thereby fill the space when bonding.

The first wiring board 101, together with the side surfaces thereof, is sealed with a sealing resin 105 which is a material different from that of the underfill 122 and is obtained by adding silica, titanium oxide, aluminum oxide, magnesium oxide, zinc oxide, etc. as a filler, to one of an epoxy resin, silicone resin, acrylic resin, urethane resin, polyester resin, and oxetane resin, or a mixture of two or more of these resins, which is formed using compression molding, transfer molding, or the like. In Fig. 1, the first wiring board 101 is sealed with the material together with the side surfaces thereof; however, as long as the semiconductor elements 104 are sealed and encapsulated, the design can be appropriately changed. For example, in a mode, the side surfaces of the semiconductor elements 104 may be sealed, while the side surfaces of the first wiring board 101 may not be sealed.

Generally, the intervals between the semiconductor element-interposer joints 121 are smaller than the intervals between the interposer-FC-BGA joints 119. Therefore, in the first wiring board 101, the first surface to which the semiconductor elements 104 are bonded is required to have wiring finer than the surface to which the FC-BGA board is bonded. For example, in order to meet the usage of currently used high bandwidth memories (HBM), the wiring width on the first surface of the first wiring board 101 is required to be around 1 µm or more and 5 µm or less. For example, if the wiring width is 2 µm, the wiring height is 2 µm, and the thickness of an insulating layer portions between wires is 2 µm, the thickness of one layer including the wiring will be 4 µm and, with this thickness, two wiring layers may be formed. If the joints between the first and second wiring boards 101 and 103 and the joints between the first wiring board 101 and the semiconductor elements 104 have an electrode thickness of 10 µm, the total thickness of the first wiring board 101 will be around 28 µm.

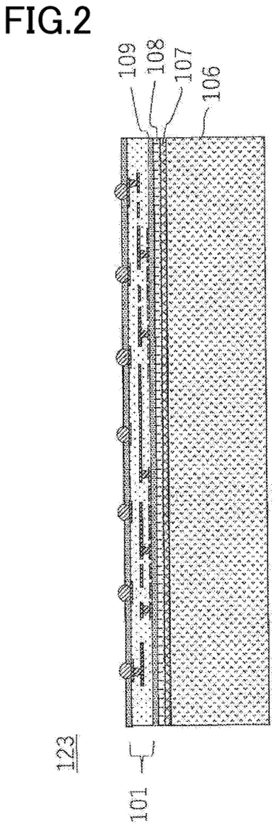

Fig. 2 is a cross-sectional view illustrating the configuration of a board unit with support according to an embodiment of the present invention. As mentioned above, the total thickness of the first wiring board 101 is around 28 µm which is so thin that it is difficult to bond it as it is to the second wiring board 103. Therefore, as shown in Fig. 2, a support 106 can be effectively used to secure rigidity. The rigid support 106, which is less likely to have deformation, is also advantageous for forming the wiring having the width and height of around 2 µm. For the reasons described above, the first wiring board 101 is formed on the rigid support 106, as shown in Fig. 2, via a release layer 107, a laser absorption layer 108, and a first seed layer 109. Layers other than the release layer 107, the laser absorption layer 108, and the first seed layer 109 may be provided on the support 106.

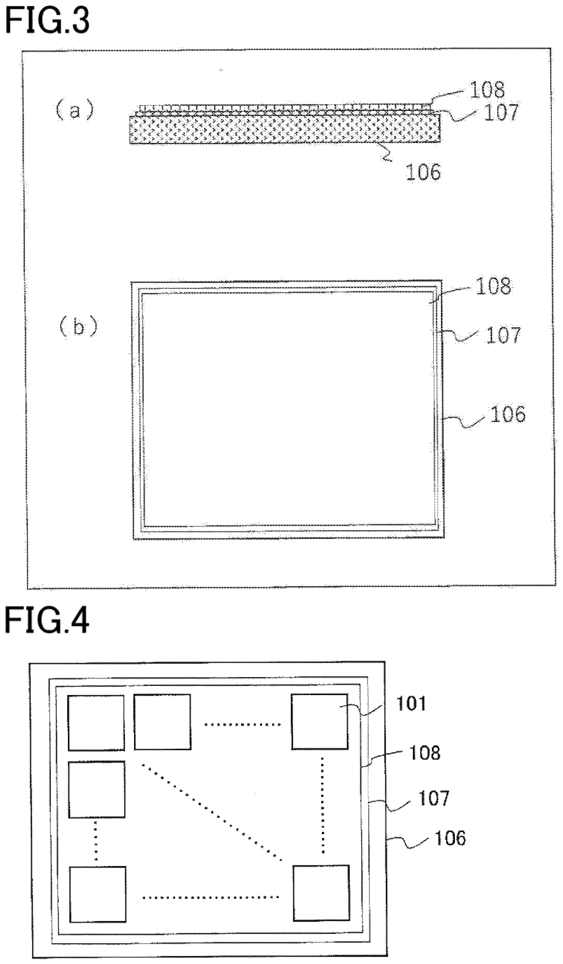

Referring to Figs. 3 and 4, an example of using a rectangular plate-like member as the support 106 will be described. Fig. 3 is a set of diagrams illustrating a state in which a release layer and a laser absorption layer are formed on a support. Specifically, Fig. 3(a) shows a state in which a release layer 107 and a laser absorption layer 108 are formed on the upper surface of the support 106, and Fig. 3(b) is a plan view illustrating the support 106, the release layer 107, and the laser absorption layer 108 as viewed perpendicularly to the support 106. Fig. 4 is a plan view illustrating a state in which a plurality of second wiring boards are disposed on the support. One surface of the support 106 is provided with the release layer 107 and the laser absorption layer 108 which are required when separating the support 106 in the later process.

The laser absorption layer 108 may be formed into the same planar shape as the release layer 107 but, as shown in Figs. 3(a) and 3(b), the laser absorption layer 108 does not have to be formed at the peripheral edge portion of the release layer 107. The area of the release layer 107 which is not covered with the laser absorption layer 108, as shown in Fig. 3, may be obtained by forming the laser absorption layer 108 on the entire upper surface of the release layer 107, followed by removing part of the laser absorption layer 108 covering the peripheral portion of the release layer 107. As the process of removing part of the laser absorption layer 108, a protective film may be formed on the peripheral portion of the release layer 107 before forming the laser absorption layer 108, followed by forming a laser absorption layer 108 on the upper surfaces of the release layer 107 and the protective film and further followed by removing the protective film, so that part of the laser absorption layer formed on the upper surface of the protective film is removed, i.e., part of the laser absorption layer is removed from the peripheral portion of the release layer 107.

Since the release layer 107 becomes separable due to heat generated when the laser absorption layer 108 absorbs laser, it is preferred that the release layer 107 is in contact with the laser absorption layer 108. If the laser absorption layer 108 has a region contacting the support 106, separation may become difficult and, therefore, the laser absorption layer 108 is formed in a region inside the release layer 107 in plan view. As shown in Fig. 4, the plurality of first wiring boards 101 on the support 106 are disposed in a region inside the laser absorption layer 108, so that the support 106 can be separated from the first wiring boards 101 with high efficiency.

In the present embodiment, as shown in Fig. 4, a plurality of first wiring boards 101 are disposed on the support 106 to form a board unit formed of the plurality of first wiring boards 101. The support 106 described in the present embodiment is a panel that is a rectangular plate-like member. However, the support 106 may be, for example a circular wafer.

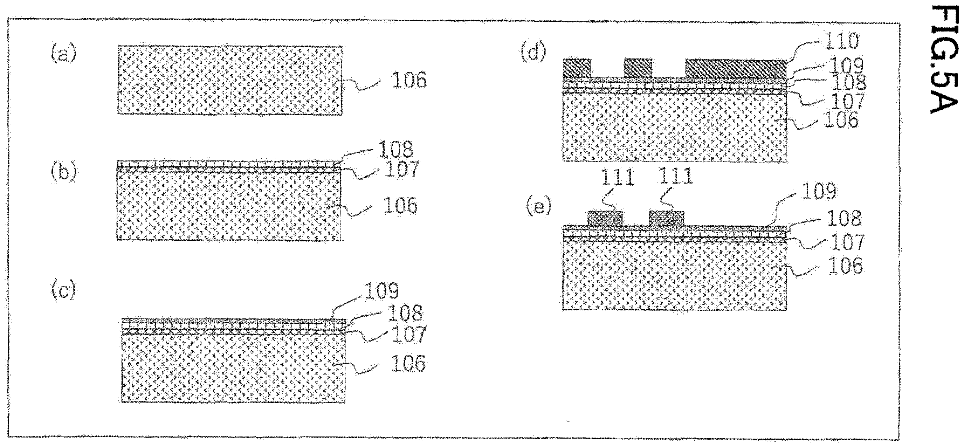

Referring to Figs. 5A to 5C, an example of a process of producing an interposer (first wiring board 101) on the support 106 according to an embodiment of the present invention will be described. Figs. 5A to 5C are each a set of cross-sectional views illustrating an example of a process of producing a board unit with support, according to an embodiment of the present invention.

As shown in Fig. 5A(a), a support 106 is prepared. The support 106, from which the release layer 107 and the laser absorption layer 108 will be separated using laser light irradiation, is required to have translucency and thus glass, for example, can be used for the support 106. Glass has good rigidity and is suitable for forming a fine pattern of the first wiring board 101. In addition, glass has a low coefficient of thermal expansion (CTE) and is resistant to strain and therefore is excellent in securing pattern placement accuracy and flatness.

If glass is used as the support 106, the thickness of the glass is preferred to be large, e.g., 0.7 mm or more, and more preferred to be 1.1 mm or more, from the perspective of suppressing the occurrence of warpage in the production process. Furthermore, the CTE of the glass is preferred to be 3 ppm or more and 15 ppm or less, and is more preferred to be around 9 ppm from the perspective of the CTEs of the second wiring board 103 and the semiconductor elements 104.

Next, as shown in Fig. 5A(b), a release layer 107 and a laser absorption layer 108, which are required for separating the support 106 in a later process, are formed in this order on one surface of the support 106.

The release layer 107 can be selected from, for example, organic resins such as epoxy resins, polyimide resins, polyurethane resins, silicone resins, polyester resins, oxetane resins, maleimide resins, and acrylic resins. The release layer 107 may be formed of a plurality of layers, the configuration of which should not be limited by the present embodiment. For example, a protective layer may be provided on the release layer 107 for the purpose of protecting the multilayer wiring layer formed on the support 106.

The method of forming the release layer 107 in the case of using a liquid organic resin can be selected from slit coating, curtain coating, die coating, spray coating, electrostatic coating, inkjet coating, gravure coating, screen printing, gravure offset printing, spin coating, and doctor coating. In the case of using a film-like organic resin, lamination, vacuum lamination, vacuum pressing, or the like can be applied.

These release layers 107 are preferred to have a thickness of 10 nm or more. If the thickness is 10 nm or less, the organic resin may be difficult to form. The upper limit of the thickness is limited by the laser light transmittance. Laser light applied from the support 106 side is required to pass through the release layer 107 and reach the laser absorption layer 108. Therefore, the release layer 107 is preferred to transmit 50% or more of infrared laser light, and, from the perspective of reducing laser output, more preferred to transmit 80% or more.

A material that absorbs infrared light can be selected as a material for the laser absorption layer 108. Specifically, the laser absorption layer 108 can be formed using elements selected from tungsten, molybdenum, titanium, tantalum, niobium, nickel, cobalt, zirconium, zinc, ruthenium, rhodium, palladium, osmium, iridium, and silicon, or alloys or compounds containing these elements.

The method of forming the laser absorption layer 108 may be vacuum deposition, sputtering, ion plating, MBE, laser ablation, CVD, or the like. The laser absorption layer 108 is preferred to have a thickness of 1 nm or more and 500 nm or less. At 1 nm or less, the layer does not function as a continuous film and cannot absorb laser. At 500 nm or more, the load placed on the processing may increase because this layer is removed after separation of the support. The thickness is more preferred to be 5 nm or more and 100 nm or less. Considering heat generation due to infrared light absorption, the light absorption rate is preferred to be 50% or more. For example, a release layer 107 of 500 nm polyimide resin, and a laser absorption layer 108 of 50 nm titanium can be formed, and glass can be used as the support 106.

Next, referring to Fig. 5A(c) and the subsequent drawings, a process of forming a first wiring board 101 on the upper surface of the release layer will be described.

First, a first seed layer 109 is formed on the laser absorption layer 108 in a vacuum. The first seed layer 109 serves as a power supply layer for electroplating when forming wiring. The first seed layer 109 can be formed using, for example, sputtering, CVD, or the like, and examples of the material include Cu, Ni, Al, Ti, Cr, Mo, W, Ta, Au, Ir, Ru, Pd, Pt, AlSi, AlSiCu, AlCu, NiFe, ITO, IZO, AZO, ZnO, PZT, TiN, Cu₃N₄, and Cu alloys, which can be used singly or in combination of two or more. From the perspective of electrical characteristics, ease of preparation, and cost, a titanium layer and a copper layer are preferred to be sequentially formed by sputtering. The titanium layer secures adhesion with the copper layer, while the copper layer mainly serves as a power supply layer for electroplating. The total thickness of the titanium and copper layers is preferred to be 1 µm or less as a power supply layer for electroplating and thus can be, for example, Ti: 50 nm and Cu: 300 nm.

In order to secure adhesion between the laser absorption layer 108 and the first seed layer 109, the same material, i.e., titanium, may be used for them. Use of the same material enables removal of all layers together after separation of the support 106, and can simplify the processing.

Next, as shown in Fig. 5A(d), a first resist pattern 110 is formed on the first seed layer 109. The first resist pattern 110 can be formed using a known photolithography method.

After that, as shown in Fig. 5A(e), a conductor layer (first electrodes) 111 is formed by electroplating, followed by removing the first resist pattern 110. The conductor layer 111 will be used as electrodes for bonding to semiconductor elements 104 (junction electrodes). In this case, the junction electrodes are preferred to have a thickness of 5 µm or more.

Thus, the first surface of the first wiring board 101 is provided with electrodes that can be bonded to at least one semiconductor element. The electroplating used for forming the conductor layer 111 may be electroplating of nickel, copper, chromium, Pd, gold, rhodium, iridium, or the like, among which, copper electroplating is preferable from the perspective of ease, cost, and electrical conductivity. The thickness of the electroplated copper is preferred to be 1 µm or more and 30 µm or less from the perspective of circuit connection reliability, manufacturing cost, and the like. The first resist pattern 110 can be removed using a known stripping liquid such as alkaline solvents.

Next, as shown in Fig. 5B(f), an insulating resin layer 112 is formed. The insulating resin layer 112 is formed so that the conductor layer 111 is embedded therein. The insulating resin layer 112 can be formed by, for example, by spin-coating a photosensitive epoxy resin. Photosensitive epoxy resins can be cured at relatively low temperatures, and are less likely to shrink due to curing after formation, and thus are excellent in fine pattern formation thereafter.

Other than spin coating using a photosensitive epoxy resin, the insulating resin layer 112 can be formed by subjecting an insulating resin film to compression curing using a vacuum laminator. In this case, an insulating film with good flatness can be formed. Other than these methods, for example, a polyimide may be used as an insulating resin.

Next, as shown in Fig. 5B(g), openings are formed in the insulating resin layer 112 using photolithography. The openings are formed so as to expose part of the conductor layer 111. The openings may be subjected to plasma treatment for the purpose of removing residues produced during development.

Next, as shown in Fig. 5B(h), a second seed layer 113 is provided covering the conductor layer 111 exposed in the openings and at least regions of the insulating resin layer 112 in which a conductor layer 115 described later will be formed. The second seed layer 113 has a configuration similar to the first seed layer 109 described above, but the configuration as well as the thickness can be changed as appropriate. For example, the second seed layer 113 can be formed by sputtering to produce Ti: 50 nm and Cu: 300 nm.

Next, as shown in Fig. 5B(i), a second resist pattern 114 is formed on the second seed layer 113, and a conductor layer (wiring layer) 15 is formed by electroplating in the openings of the second resist pattern 114. The conductor layer 115, which serves as a wiring layer inside the first wiring board 101, may be formed of copper, for example. After that, as shown in Fig. 5B(j), the second resist pattern 114 is removed. After that, unnecessary portions of the second seed layer 113 are etched away.

Next, processing of Figs. 5B(f) to 5B(j) is repeated to obtain a first wiring board 101 including multiple conductor layers (wiring layers) 15 as shown in Fig. 5B(k). A conductor layer (second electrodes) 16 formed on the outermost surface serves as junction electrodes to the second wiring board 103. In this case, the junction electrodes are preferred to have a thickness of 5 µm or more. Thus, the second surface of the first wiring board 101 is provided with electrodes that can be bonded to the second wiring board (FC-BGA board) 3.

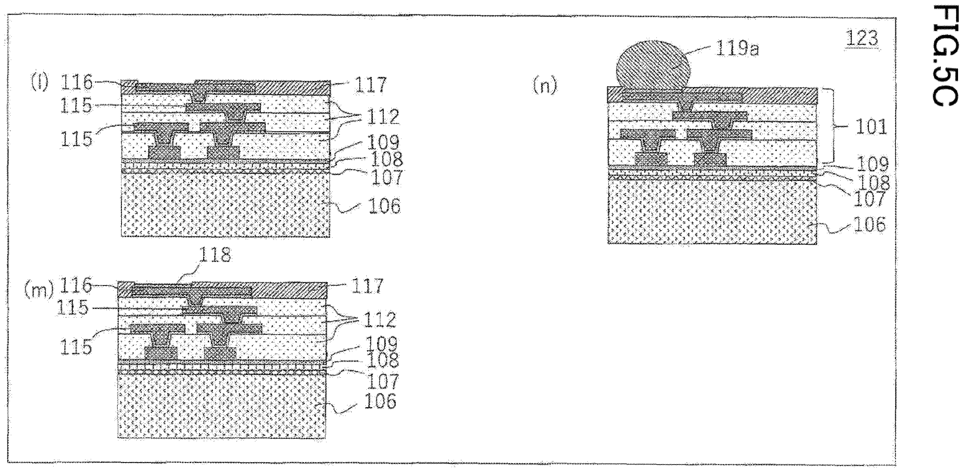

Next, as shown in Fig. 5C(l), an outermost surface insulating resin layer 117 is formed on the first wiring board 101, followed by forming openings therein using photolithography to expose at least part of the conductor layer 116. The outermost surface insulating resin layer 117 is formed, for example, using a photosensitive epoxy resin. The outermost surface insulating resin layer 117 may be made of the same material as that of the insulating resin layer 112.

Next, as shown in Fig. 5C(m), a surface treatment layer 118 may be provided to prevent oxidation of the surface of the conductor layer 116 and enhance wettability of solder bumps. The surface treatment layer 118 may be formed by Ni/Pd/Au electroless plating. It should be noted that an OSP (surface treatment using organic solderability preservative water-soluble preflux) film may be formed as the surface treatment layer 118. Plating may be appropriately selected from tin electroless plating, Ni/Au electroless plating, and other electroplating methods according to the application.

Next, as shown in Fig. 5C(n), a solder material is mounted on the surface treatment layer 118, melted, cooled, and fixed to obtain solder bumps as interposer-FC-BGA joints 119a on the first wiring board 101 side. Thus, a board unit 123 with support, that is, a first wiring board (interposer) 1 formed on the support 106, is completed.

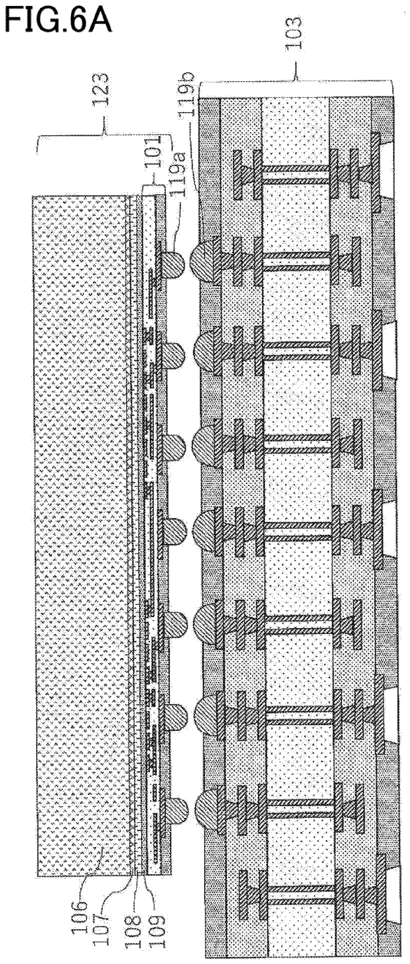

Referring to Figs. 6A to 6E, an example of a process of bonding between the first wiring board (interposer) 1 formed on the support 106 and the second wiring board (FC-BGA board) 3 will be described. Figs. 6A to 6E are cross-sectional views illustrating an example of a method of producing a board unit according to an embodiment of the present invention.

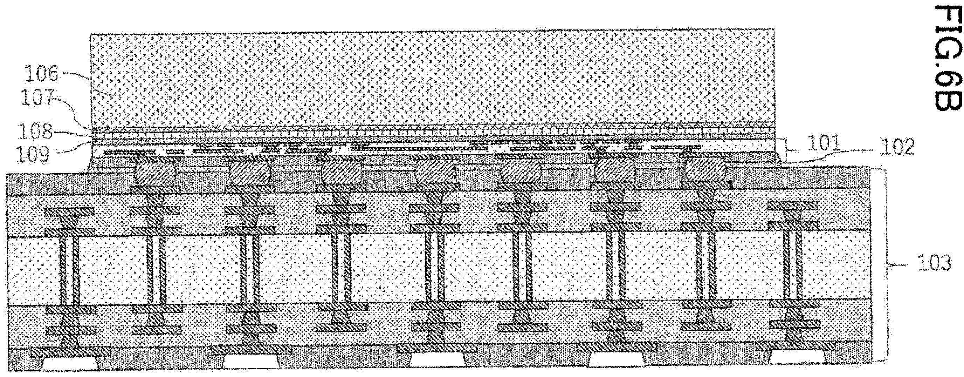

As shown in Fig. 6A, conforming to the interposer-FC-BGA joints 119a on the first wiring board 101 side, solder bumps as interposer-FC-BGA joints 119b on the second wiring board 103 side are designed. The first wiring board 101 formed on the support 106 is placed on the second wiring board 103 as produced and, as shown in Fig. 6B, the first wiring board 101 formed on the support 106 and the second wiring board 103 are bonded together, followed by filling an underfill 102 therebetween to fix the first and second wiring boards 101 and 103 and seal the interposer-FC-BGA joints 119.

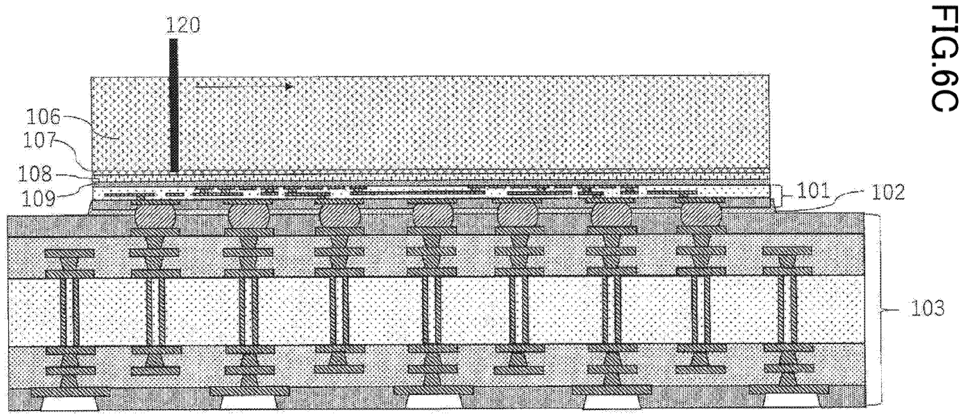

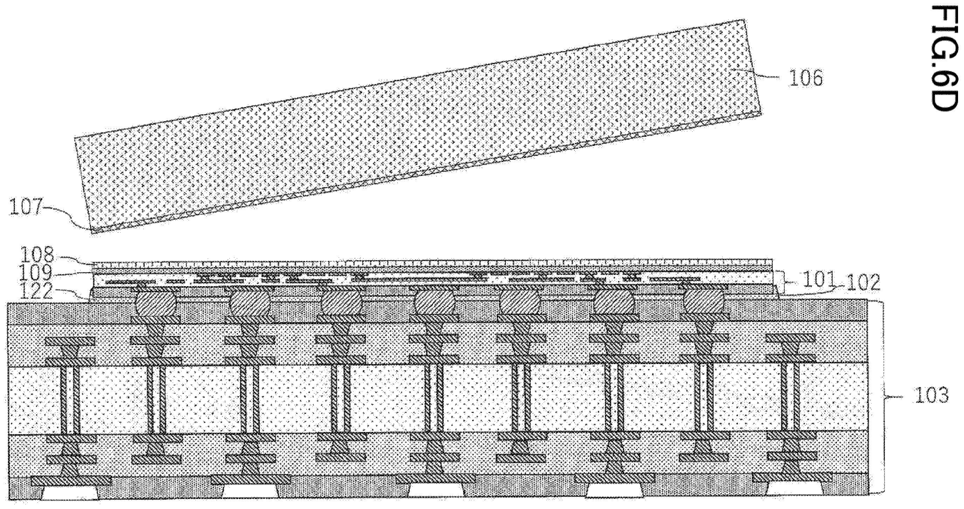

Next, as shown in Fig. 6C, laser light 120 is applied to the laser absorption layer 108 formed at the interface with the release layer 107, from the rear surface of the support 106, i.e., from the surface of the support 106 facing away from the surface provided with the first wiring board 101. The release layer 107 is decomposed by the heat generated due to the laser absorption layer 108 absorbing the laser light 120, and the release layer 107 and the laser absorption layer 108 are brought into a separable state. Thus, as shown in Fig. 6D, the support 106 can be detached.

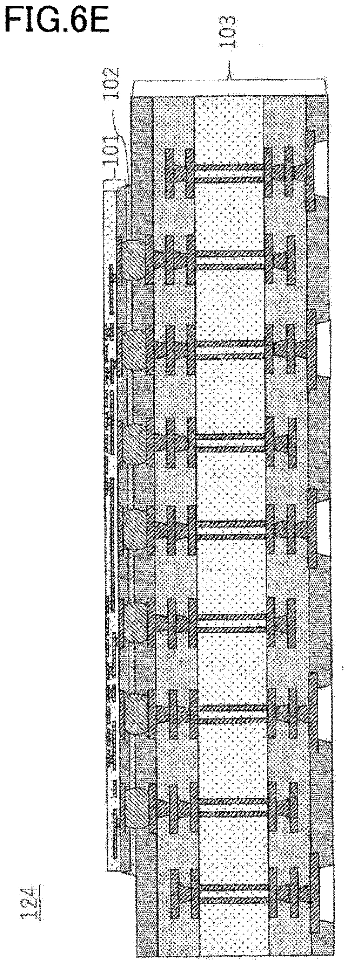

Next, the laser absorption layer 108 and the first seed layer 109 are removed to obtain a board as shown in Fig. 6E. For example, if titanium is used as the laser absorption layer 108, this layer can be dissolved and removed using an alkaline etching agent. In this case, if the first seed layer 109 is titanium, this layer can be simultaneously dissolved and removed.

The remaining copper layer of the first seed layer 109 can be dissolved and removed using an acid-based etching agent. In this way, the first wiring board (interposer) 1 and the second wiring board (FC-BGA board) 3 are bonded together.

After that, the conductor layer 111 exposed to the surface may be surface-treated using Ni/Pd/Au electroless plating, OSP, tin electroless plating, Ni/Au electroless plating, or the like to prevent oxidation and enhance wettability of the solder bumps. Thus, a board unit 124 from which the support has been removed is completed.

After that, the semiconductor elements 104 are bonded to the board unit 124 from which the support has been removed, and the underfill 122 is filled to fix the semiconductor elements 104 and the first wiring board 101 and to seal the semiconductor element-interposer joints 121, followed by sealing the semiconductor elements 104 with the sealing resin 105 to complete the semiconductor device 125.

### <Second Embodiment>

Next, a description will be given of a method of producing a semiconductor device 126 in which a first wiring board 101 and semiconductor elements 104 are mounted to a second wiring board 103, according to a second embodiment. The method of producing the first wiring board 101 on the support 106 is similar between the first and second embodiments. In the first embodiment, the first wiring board 101 is separated from the support 106 and then bonded to the second wiring board 103, followed by bonding the semiconductor elements 104. However, the second embodiment is different from the first embodiment in that the semiconductor elements 104 are bonded to the first wiring board 101 formed on the support 106, and then the first wiring board 101 is separated together with the semiconductor elements 104 from the support 106, followed by bonding the first wiring board 101 together with the semiconductor elements 104 to the second wiring board 103.

Accordingly, in the first wiring board 101 of the first embodiment, the surface facing away from the surface provided with the support 106 is the second surface of the first wiring board 101, and electrodes for bonding to the second wiring board 103 are provided to this second surface, while the support 106-side surface is the first surface of the first wiring board 101, and the electrodes for bonding to the semiconductor elements 104 are provided to this first surface. However, in the first wiring board 101 of the second embodiment, the surface facing away from the surface provided with the support is the first surface of the first wiring board 101, and electrodes for bonding to the semiconductor elements 104 are provided to this second surface, while the support-side surface is the second surface of the first wiring board 101, and the electrodes for bonding to the second wiring board 103 are provided to this second surface.

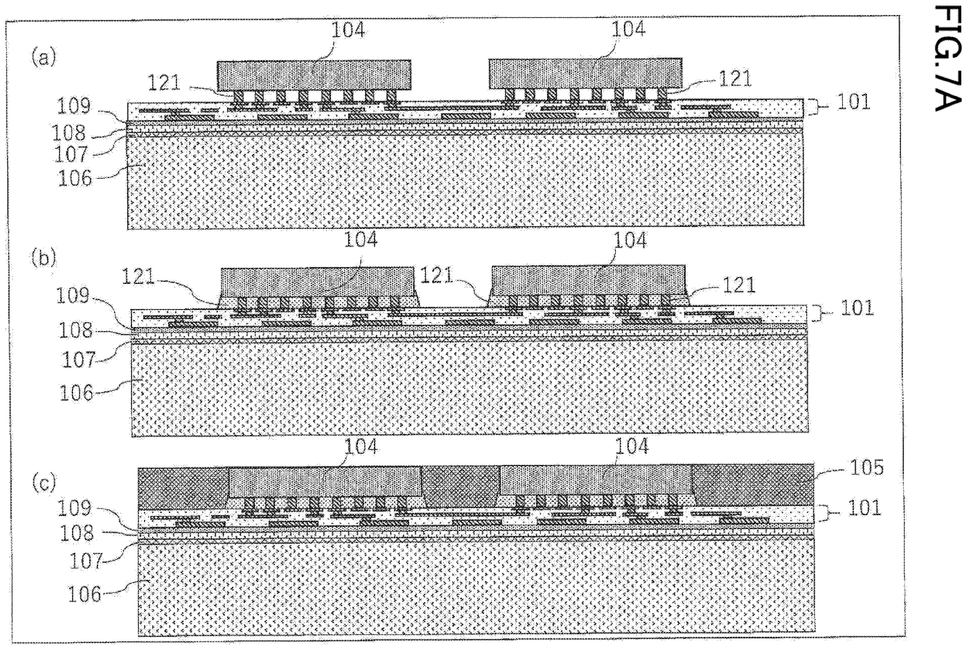

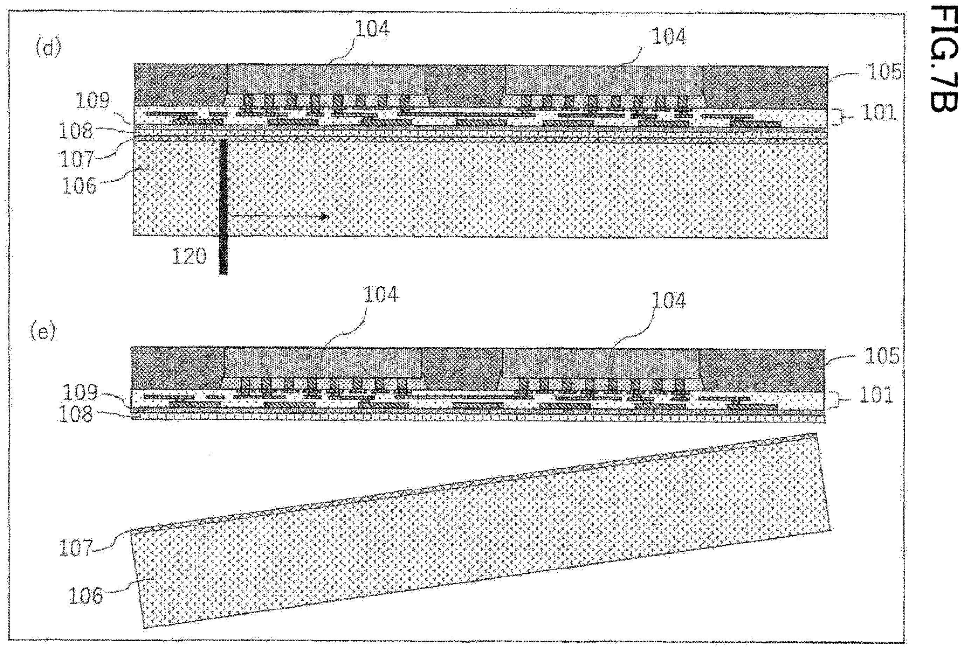

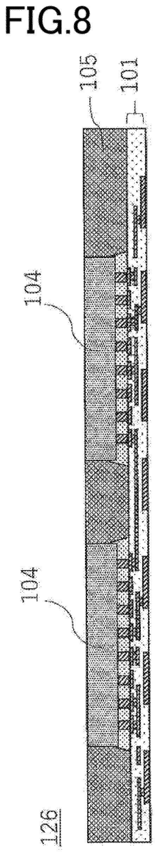

Referring to Fits. 7A, 7B and 8, an example of a process of producing the semiconductor device 126 according to the second embodiment of the present invention will be described. Figs. 7A and 7B each show a set of cross-sectional views illustrating an example of a method of producing a semiconductor device according to an embodiment of the present invention. Fig. 8 is a cross-sectional view illustrating an example of a semiconductor device according to an embodiment of the present invention.

As shown in Fig. 7A(a), the semiconductor elements 104 are bonded to the surface of the first wiring board 101 facing away from the surface provided with the support 106, via copper pillars or solder. These joints are referred to as semiconductor element-interposer joints 121.

Next, as shown in Fig. 7A(b), an underfill 122 is filled in the vicinity of the semiconductor element-interposer joints 121 to fix the semiconductor elements 104 and the first wiring board 101 and to seal the semiconductor element-interposer joints 121.

Next, as shown in Fig. 7A(c), a sealing resin 105 is formed to seal the semiconductor elements 104. The sealing resin 105, which is different from the material of the underfill 122, is obtained by adding silica, titanium oxide, aluminum oxide, magnesium oxide, zinc oxide, etc. as a filler, to one of an epoxy resin, silicone resin, acrylic resin, urethane resin, polyester resin, and oxetane resin, or a mixture of two or more of these resins, and is formed using compression molding, transfer molding, or the like.

Next, the support 106 is separated. As shown in Fig. 7B(d), laser light 120 is applied to the laser absorption layer 108 to separate the first wiring board 101, to which the semiconductor elements are mounted, from the support 106. The laser light 120 is applied to the laser absorption layer 108 formed at the interface with the support 106, from the rear surface of the support 106, i.e., from the surface of the support 106 facing away from the surface provided with the semiconductor elements 104. The heat generated due to the laser absorption layer 108 absorbing the laser light 120 decomposes the release layer 107 and brings it into a separable state, so that, as shown in Fig. 7B(e), the support 106 can be detached.

Next, the laser absorption layer 108 and the first seed layer 109 are removed. In the present embodiment, for example, titanium is used for the laser absorption layer 108, and in this case, the laser absorption layer 108 can be dissolved and removed using an alkaline etching agent. In this case, if the first seed layer 109 is titanium, the laser absorption layer 108 and the first seed layer 109 can be simultaneously dissolved and removed. The remaining copper layer of the first seed layer 109 can be dissolved and removed using an acid-based etching agent. Thus, as shown in Fig. 8, a semiconductor device 126 in which the first wiring board (interposer) 1 and the semiconductor elements 104 are bonded together can be obtained.

After that, the conductor layer 111 exposed to the surface may be surface-treated using Ni/Pd/Au electroless plating, OSP, tin electroless plating, Ni/Au electroless plating, or the like to prevent oxidation and enhance wettability of the solder bumps to provide a semiconductor device 126.

After that, the semiconductor device 126 is bonded to the second wiring board (FC-BGA substrate ) 3 and an underfill 102 is filled therebetween to fix the semiconductor device 126 and the second wiring board 103 and to seal the interposer-FC-BGA joints 119, thereby completing the semiconductor device 125 integrated with the first wiring board 101.

As described above, the release layer and the laser absorption layer are provided in this order in the method in which a wiring board is formed on a support via a release layer, and the wiring board is separated thereafter from the support. Thus, there can be provided a board unit with support which facilitates separation of the wiring board, does not require a high-energy UV laser and which is less likely to form residues of the release layer after separation of the support, a board unit, a semiconductor device, a board unit with support, and a method of producing them.

### <Third Embodiment>

The present embodiment has an aim of providing a wiring board with support in which the support can be easily separated from the wiring board.

In the following description, the expression "functional devices" refers to devices which are activated with a supply of electrical power and/or electrical signals, devices which output electrical power and/or electrical signals due to stimulation from outside, or devices which are activated with a supply of electrical power and/or electrical signals and which output electrical power and/or electrical signals due to stimulation from outside. Functional devices may be, for example, in the forms of chips, such as semiconductor chips or chips in which circuits or elements are formed on a substrate, such as a glass substrate, made of a material other than semiconductor materials. Functional devices can include, for example, one or more from among large-scale integrated circuits (LSIs), memories, imaging devices, light-emitting devices, and microelectromechanical systems (MEMSs). MEMSs may include, for example, one or more from among pressure sensors, acceleration sensors, gyro sensors, tilt sensors, microphones, and acoustic sensor. According to an example, functional devices may be semiconductor chips including LSIs.

### <Wiring board with support>

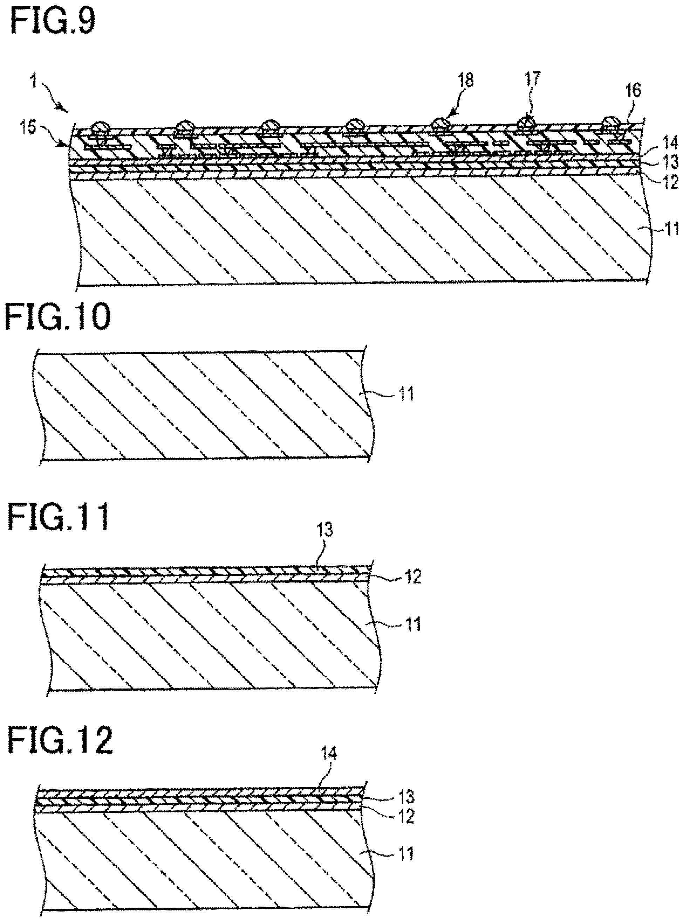

Fig. 9 is a schematic cross-sectional view illustrating a wiring board with support, according to an embodiment of the present invention.

A wiring board 1 with support shown in Fig. 9 includes a support 11, light absorption layer 12, a release layer 13, a first seed layer 14, a wiring board 15, an outermost surface insulating layer 16, a surface treatment layer 17, and first metal bumps 18. The wiring board 1 with support is used for, for example, transferring the wiring board 15 to an FC-BGA board. The transfer is performed by, for example, applying laser light to the light absorption layer 12, and separating the support 11 from the wiring board 15.

The support 11 has a support surface, and transmits light with a specific wavelength in the direction perpendicular to the support surface. The support 11 may have transparency, for example.

The specific wavelength may be, for example, in the ultraviolet or infrared wavelength region. If the specific wavelength is in the ultraviolet wavelength region, the specific wavelength may be, for example, in the range of 150 nm to 400 nm. If the specific wavelength is in the infrared wavelength region, the specific wavelength may be, for example, in the range of 700 nm to 2,000 nm.

The material of the support 11 may be, for example, glass, polycarbonate, or acrylic or silicone material. Silicone can be used if the specific wavelength is in the infrared wavelength region.

The material of the support 11 is preferred to be glass. If the support 11 is made of glass, the support 11 with a sufficient thickness can be excellent in shape retention. Using such a support 11, a wiring board 15 having a fine wiring pattern can be easily formed.

The glass is preferred to have a coefficient of linear expansion (CTE: coefficient of thermal expansion) in the range of 3 ppm or more and 15 ppm or less, and more preferred to be in the range of 3.3 ppm to 12.6 ppm. If the coefficient of linear expansion is in the range of 3 ppm or more and 15 ppm or less, the wiring pattern can be easily arranged with high accuracy in the wiring board 15, and a flat wiring pattern 15 can be easily formed. If the coefficient of linear expansion of the glass is around 9 ppm, it is approximate to the coefficient of linear expansion of FC-BGA boards and that of semiconductor chips and, therefore, is less likely to cause warpage or the like.

The thickness of the support 11 is preferred to be 0.7 mm or more, and is more preferred to be 1.1 mm or more. If the support 11 is excessively thin, warpage tends to occur. If the support 11 is excessively thick, laser light absorption by the support 11 tends to increase. If the support 11 is made of glass and the thickness thereof is in the above range, warpage is less likely to occur in the production process.

The support 11 may have a rectangular or circular shape.

The light absorption layer 12 is interposed between the support 11 and the release layer 13. Compared to the release layer 13, the light absorption layer 12 exhibits higher light absorbance. The light absorption layer 12 generates heat by absorbing light having the above specific wavelength, and transfers the heat to the release layer 13.

Materials used for the light absorption layer 12 may be metals, for example. These metals are preferred to have an attenuation coefficient in the range of 3.3 to 5.32 at any wavelength in the range of 1,033 nm to 1,079 nm. Examples of the metals having an attenuation coefficient in the above range include titanium, chromium, tungsten, nickel, molybdenum, niobium, and tantalum.

The attenuation coefficient can be measured, for example, using spectroscopic ellipsometry.

The metals are preferred to have a refractive index in the range of 0.96 to 3.35, and more preferably in the range of 2.29 to 3.35, at any wavelength in the range of 1,033 nm to 1,079 nm. Examples of the metals having the refractive index in the range of 0.96 to 3.35 include titanium, chromium, tungsten, nickel, molybdenum, niobium, and tantalum. Examples of the metals having the refractive index in the range of 2.29 to 3.35 include titanium, chromium, tungsten, nickel, and molybdenum.

The refractive index can be measured, for example, using spectroscopic ellipsometry.

The materials of the light absorption layer 12 are preferred to have an attenuation coefficient in the range of 3.3 to 5.31 at any wavelength in the range of 1,033 nm to 1,079 nm, and to have a refractive index in the range of 0.96 to 3.35 at any wavelength in the range of 1,033 nm to 1,079 nm. Examples of such materials include titanium, chromium, tungsten, nickel, molybdenum, niobium, and tantalum.

Table 1 shows attenuation coefficients and refractive indices in any of wavelength in the range of 1,033 nm to 1,079 nm for titanium, chromium, tungsten, niobium, molybdenum, niobium, and tantalum.

**[Table 1]**

| | Wavelength (nm) | Refractive index | Attenuation coefficient |
|---|---|---|---|
| Titanium (Ti) | 1033.2 | 3.35 | 3.3 |
| Tungsten (W) | 1078.3 | 3.011 | 3.8447 |
| Molybdenum (Mo) | 1078.3 | 2.2931 | 4.5194 |
| Chromium (Cr) | 1033.2 | 3.5 | 3.58 |
| Nickel (Ni) | 1078.3 | 2.9113 | 5.2331 |
| Niobium (Nb) | 1078 | 1.55 | 5.18 |
| Tantalum (Ta) | 1060 | 0.9669 | 5.3142 |

Examples of the materials of the light absorption layer 12 include one or more metals selected from the group consisting of titanium, chromium, tungsten, nickel, molybdenum, niobium, and tantalum, and alloys or compounds containing these metals. It is preferred that the materials of the light absorption layer 12 are one or more metals selected from the group consisting of titanium, chromium, tungsten, nickel, and molybdenum, or alloys or compounds containing these metals. It is more preferred that the materials of the light absorption layer 12 are titanium, or alloys or compounds containing titanium.

The light absorption layer 12 can be formed, for example, using vacuum deposition such as molecular beam epitaxy (MBE), sputtering, ion plating, laser abrasion, or chemical vapor deposition (CVD).

The thickness of the light absorption layer 12 is preferred to be in the range of 1 nm to 500 nm, and is more preferred to be in the range of 5 nm to 100 nm. If the light absorption layer 12 is excessively thin, it cannot sufficiently absorb laser light when the wiring board 1 with support is irradiated with laser light and, therefore, it will be difficult to separate the support 11 from the wiring board 15 with ease. If the light absorption layer 12 is excessively thick, heat generated when the light absorption layer 12 is irradiated with laser light tends to transfer in the in-plane direction of the light absorption layer 12 from the irradiated area and, therefore, the irradiated area is less likely have sufficiently high temperatures.

The release layer 13 is interposed between the support 11 and the wiring board 15. The release layer 13 decreases adhesion in response to heating. "To decrease adhesion" refers to the release layer 13 being separated from the light absorption layer 12, or the force required for separating the release layer 13 and the light absorption layer 12 decreasing.

Examples of the materials of the release layer 13 include resins such as epoxy resins, polyimide resins, polyurethane resins, silicone resins, polyester resins, oxetane resins, maleimide resins, and acrylic resins. As a polyimide resin, for example, UPIA (trademark) manufactured by UBE Corporation can be used.

The thickness of the release layer 13 is preferred to be, for example, in the range of 10 nm to 50 µm, more preferred to be in the range of 10 nm to 1 µm, and even more preferred to be in the range of 10 nm to 0.5 µm. If the release layer 13 is excessively thin, it will be difficult to form the release layer 13 uniformly. If the release layer 13 is excessively thick, it will be difficult to form a wiring board 15 having good flatness.

The release layer 13, if a liquid resin is used as a material therefor, can be formed, for example, using slit coating, curtain coating, die coating, spray coating, electrostatic coating, inkjet coating, gravure coating, screen printing, gravure offset printing, spin coating, or doctor coating.

The release layer 13, if a film-shaped resin is used as a material therefor, can be provided on the light absorption layer 12 using, for example, lamination, vacuum lamination, or vacuum pressing.

The release layer 13 may be formed of two or more layers.

The first seed layer 14 may be, for example, a power supply layer when forming a conductor layer described later. The first seed layer 14 may contain, for example, copper, nickel, aluminum, titanium, chromium, molybdenum, tungsten, tantalum, gold, iridium, ruthenium, palladium, platinum, Al-Si alloys, Al-Si-Cu alloys, Al-Cu alloys, Ni-Fe alloys, indium tin oxide (ITO), indium zinc oxide (IZO), active zinc oxide (AZO), zinc oxide (ZnO), piezoelectric zirconate titanate (PZT), titanium nitride (TiN), Cu₃N₄, or Cu alloys, singly or as a mixture thereof.

The first seed layer 14 may be formed, for example, using sputtering or chemical vapor deposition (CVD).

The thickness of the first seed layer 14 is preferred to be 1 µm or less, and is more preferred to be in the range of 50 nm to 500 nm.

The first seed layer 14 may be formed of two or more layers. In this case, the seed layer 14 may be formed of, for example, a first metal-containing layer interposed between the release layer 13 and the wiring board 15, and a second metal-containing layer interposed between the first metal-containing layer and the wiring board 15.

The first metal-containing layer may contain titanium, for example. The second metal-containing layer may contain copper, for example. The first and second metal-containing layers may be formed using sputtering, for example. If a first metal-containing layer containing titanium is used, the first metal-containing layer may have good adhesion to the release layer 13. If a second metal-containing layer containing copper is used, the second metal-containing layer may have good adhesion to the first metal-containing layer and the conductor layer described later.

The thickness of the first metal-containing layer is preferred to be, for example, in the range of 10 nm to 100 nm. The thickness of the second metal-containing layer is preferred to be, for example, in the range of 40 nm to 400 nm.

The wiring board 15 faces the support surface of the support 11. The wiring board 15 may connect between, for example, functional devices, such as semiconductor chips, and an FC-BGA board. The wiring board 15 may be produced using a known method, for example.

The wiring board 15 may be, for example, a multilayer wiring board such as an interposer. The wiring board 15 may be formed of, for example, a built-up wiring layer. The wiring board 15 may include, for example, a fine wiring pattern. The minimum line/space width in the wiring board 15 may be, for example, in the range of 1 µm/1 µm to 5 µm/5 µm. The conductor layer included in the wiring board 15 may be formed, for example, using a damascene method or semi-additive method. The conductor layer will be described later.

Details of the wiring board 15, the outermost surface insulating layer 16, the surface treatment layer 17, and the first metal bumps 18 will be described later.

In order to protect the wiring board 15 from laser light, a protective layer may be provided between the release layer 13 and the wiring board 15.

### <Method of producing wiring board with support>

Referring to Figs. 10 to 23, an example of a method of producing the wiring board 1 with support will be described.

First, as shown in Fig. 10, a support 11 is prepared. The support 11 is assumed to be made of glass.

Next, as shown in Fig. 11, a light absorption layer 12 and a release layer 13 are formed on the support 11. Specifically, first, titanium is sputtered on the support 11. Thus, a light absorption layer 12 is formed. Next, a polyimide resin is applied onto the light absorption layer 12 using spin coating. Thus, a release layer 13 is formed.

Next, a wiring board 15 is formed.

First, as shown in Fig. 12, a first seed layer 14 is formed on the release layer 13. Herein, a first metal-containing layer and a second metal-containing layer are formed as a first seed layer 14. Specifically, first, titanium is sputtered on the release layer 13. Thus, a first metal-containing layer is formed. Next, copper is sputtered on the first metal-containing layer. Thus, a second metal-containing layer is formed.

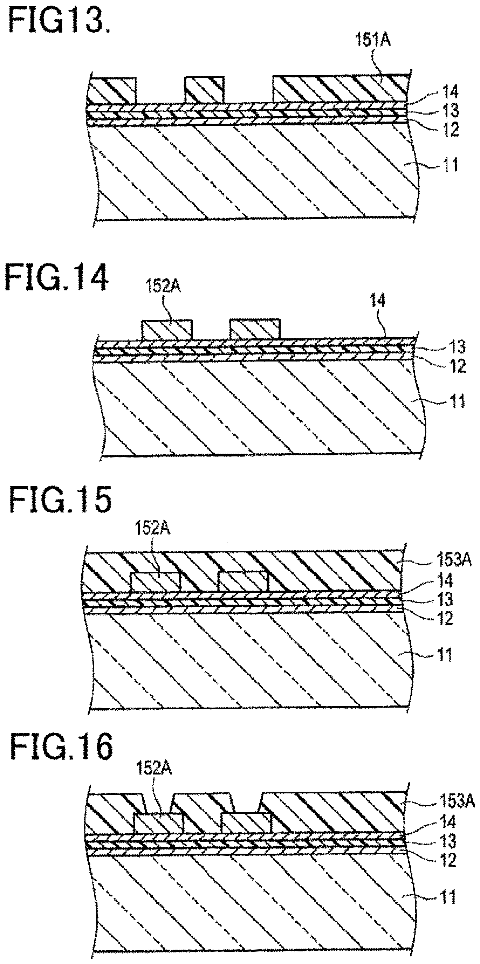

Next, as shown in Fig. 13, a resist layer 151A is formed in a pattern on the first seed layer 14. Specifically, first, a resist layer 151A is formed on the first seed layer 14 in a vacuum. After that, part of the resist layer 151A is removed using photolithography to provide openings. Thus, a resist layer 151A is formed in a pattern.

Materials for the resist layer 151A may be, for example, alkaline developable photosensitive resins.

Next, as shown in Fig. 14, a conductor layer 152A is formed on the first seed layer 14. Specifically, first, a conductor layer 152A containing copper is formed on the first seed layer 14, i.e., portions thereof not covered with the resist layer 151A, using electroplating. After that, the resist layer 151A is removed using a resist stripping liquid such as an alkaline solution. Thus, a conductor layer 152A is formed. The conductor layer 152A may serve as electrodes, for example. The conductor layer 152A may serve, for example, as electrodes used for bonding to the first wiring board described later, or electrodes used for bonding to functional devices.

If the conductor layer 152A contains copper, the conductor layer 152A can be formed easily at low cost. The conductor layer 152A containing copper have good electrical conductivity.

The conductor layer 152A may be formed of, for example, nickel, chromium, palladium, gold, or rhodium. The conductor layer 152A may be formed, for example, using electroplating.

The thickness of the conductor layer 152A is preferred to be in the range of 1 µm to 30 µm, and is more preferred to be in the range of 1 µm to 5 µm. If the conductor layer 152A is excessively thick, the production cost tends to increase. If the conductor layer 152A is excessively thin, problems may occur when bonding between the functional devices or the first wiring board described later and the wiring board 15.

Next, as shown in Fig. 15, an insulating layer 153A is formed on the first seed layer 14, i.e., portions thereof not covered with the conductor layer 152A, and on the surface of the conductor layer 152A. Specifically, a photosensitive epoxy resin is applied to portions of the first seed layer 14 not covered with the conductor layer 152A and to the surface of the conductor layer 152A using spin coating. After that, the photosensitive epoxy resin is cured. Thus, an insulating layer 153A is formed. The insulating layer 153A may be formed, for example, so that the conductor layer 152A is embedded in the insulating layer 153A.

If a photosensitive epoxy resin is used, the insulating layer 153A can be easily cured at comparatively low temperatures. Photosensitive epoxy resins are less likely to shrink due to curing and thus are excellent in forming fine wiring patterns.

Materials used for the insulating layer 153A may be polyimide resins or polyamide resins.

Instead of forming the insulating layer 153A using a photosensitive epoxy resin, the insulating layer 153A may be obtained by pressing an insulating resin film using a vacuum laminator. In this case, an insulating layer 153A having good flatness can be formed.

The thickness of the insulating layer 153A is preferred to be in the range of 0.5 µm to 50 µm, and is more preferred to be in the range of 2 µm to 15 µm. If the insulating layer 153A is excessively thick, it will be difficult to obtain a wiring board 15 having good flatness. If the insulating layer 153A is excessively thin, it will be difficult to achieve high insulation reliability.

Next, as shown in Fig. 16, one or more openings are formed in the insulating layer 153A using photolithography. The openings are formed so as to expose part of the upper surface of the conductor layer 152A.

After forming the openings, plasma treatment may be performed to remove the residues formed in the openings due to development.

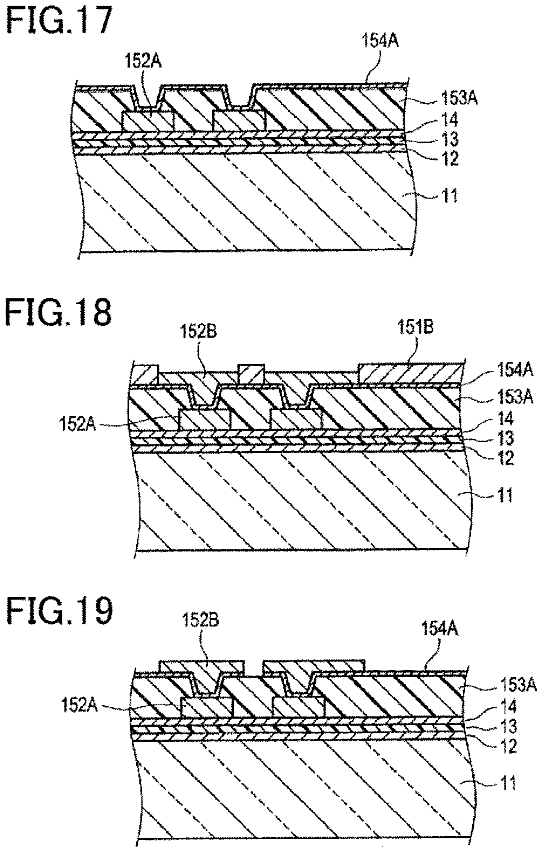

As shown in Fig. 17, a second seed layer 154A is formed on the conductor layer 152A exposed in the openings and on the surface of the insulating layer 153A.

The second seed layer 154A may contain, for example, copper, nickel, aluminum, titanium, chromium, molybdenum, tungsten, tantalum, gold, iridium, ruthenium, palladium, platinum, Al-Si alloys, Al-Si-Cu alloys, Al-Cu alloys, Ni-Fe alloys, indium tin oxide (ITO), indium zinc oxide (IZO), active zinc oxide (AZO), zinc oxide (ZnO), piezoelectric zirconate titanate (PZT), titanium nitride (TiN), Cu₃N₄, or Cu alloys, singly or as a mixture of them.

The second seed layer 154A may be formed, for example, using sputtering or chemical vapor deposition (CVD).

The thickness of the second seed layer 154A is preferred to be 1 µm or less, and is more preferred to be in the range of 50 nm to 500 nm.

The second seed layer 154A may be formed of two or more layers. In this case, the second seed layer 154A may be formed of, for example, a first metal-containing layer provided on the conductor layer 152A and the insulating layer 153A, and a second metal-containing layer provided on the conductor layer 152A and the insulating layer 153A via the first metal-containing layer.

The first metal-containing layer may contain titanium, for example. The second metal-containing layer may contain copper, for example. The first and second metal-containing layers may be formed using sputtering, for example.

In the following description, the second seed layer 154A is assumed to be formed of a first metal-containing layer containing titanium and a second metal-containing layer containing copper. Furthermore, the first and second metal-containing layers are assumed to have respective thicknesses of 50 nm and 300 nm.

Next, as shown in Fig. 18, a resist layer 151B is formed in a pattern on the second seed layer 154A. Specifically, openings are formed in the resist layer 151B so as to expose portions of the second seed layer 154A adjacent to the conductor layer 152A. After that, a conductor layer 152B is formed so as to cover the entire regions of the surface of the second seed layer 154A not covered with the resist layer 151B. The conductor layer 152B is a wiring pattern included in the wiring board 15.

The materials and forming methods described for the resist layer 151A apply to the resist layer 151B.

The materials and forming methods described for the conductor layer 152A apply to the conductor layer 152B and the conductor layer 152C described later. Herein, the conductor layer 152B is assumed to contain copper.

Next, as shown in Fig. 19, the resist layer 151B is removed. After that, portions of the second seed layer 154A not covered with the conductor layer 152B are etched away.

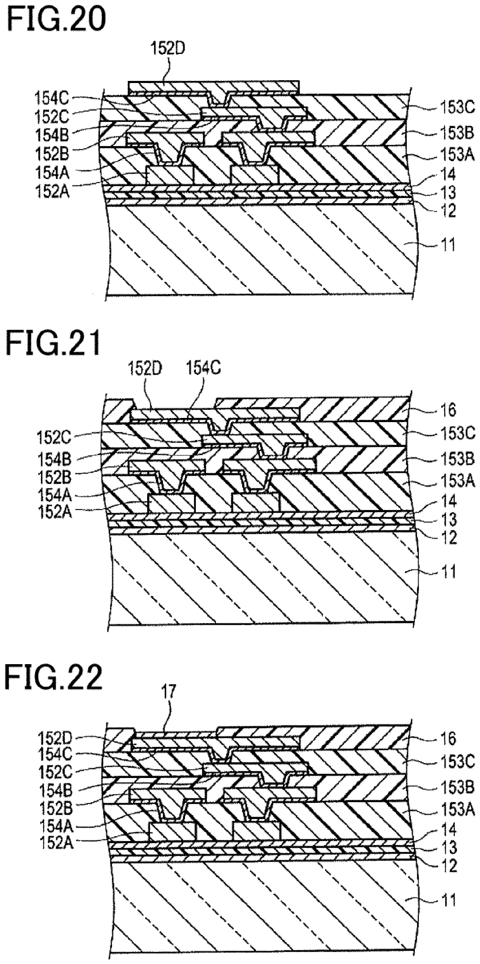

Next, the methods described referring to Figs. 15 to 19 are repeated twice to obtain the structure shown in Fig. 20. The structure shown in Fig. 20 includes conductor layers 152A, 152B, 152C and 152D, insulating layers 153A, 153B and 153C, and second seed layers 154A, 154B and 154C. The conductor layers 152B and 152C may serve as, for example, wiring of the wiring board 15. The conductor layer 152D may serve as, for example, electrodes used for bonding to the first wiring board described later, or electrodes used for bonding to the functional devices.

The conductor layer 152D is preferred to have a thickness of 5 µm or more. Thus, a wiring board 15 is formed.

The number of times of repeating the methods described referring to Figs. 15 to 19 may be one, or three or more.

Next, as shown in Fig. 21, an outermost surface insulating layer 16 is formed in a pattern on the wiring board 15. Specifically, first, an outermost surface insulating layer 16 is formed in the regions of the surface of the insulating layer 153C not covered with the second seed layer 154C and the conductor layer 152D, on the surface of the conductor layer 152D, and on the side surfaces of the second seed layer 154C. Next, openings are formed in the outermost surface insulating layer 16 using photolithography to expose at least part of the conductor layer 152D.

Materials of the outermost surface insulating layer 16 may be, for example photosensitive epoxy resins. Materials of the outermost surface insulating layer 16 may be the same as the materials of the insulating layer 153A.

Next, as shown in Fig. 22, a surface treatment layer 17 is formed covering portions of the conductor layer 152D not covered with the outermost surface insulating layer 16. The surface treatment layer 17 is provided, for example, to prevent oxidation of the surface of the conductor layer 152D and/or to improve wettability of the first metal bumps 18.

As the surface treatment layer 17, for example, a plating film such as of Ni/Pd/Au electroless plating, tin electroless plating, and Ni/Au electroless plating may be used. Alternatively, a water-soluble preflux (organic solderability preservative (OSP)) film may be used as the surface treatment layer 17.

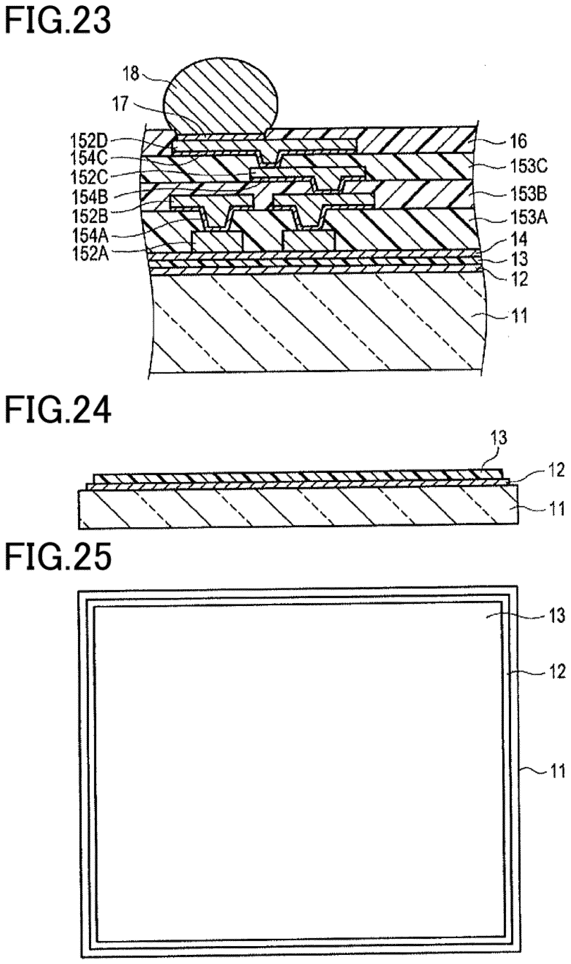

Next, as shown in Fig. 23, first metal bumps 18 are formed on the surface treatment layer 17. Specifically, for example, the material of the first metal bumps 18 is disposed on the surface treatment layer 17 and fixed by melting and cooling to form the first metal bumps 18.

Examples of the material of the first metal bumps 18 include Sn-Ag-Cu alloys, Sn-Ag alloys, and Sn-Cu alloys.

Thus, a wiring board 1 with support is obtained.

The outermost surface insulating layer 16, the surface treatment layer 17, and the first metal bumps 18 may be omitted.

The wiring width of the wiring board 15 is preferred to be, for example, in the range of 1 µm or more and 5 µm or less. In this case, the wiring board 15 can be used as interposers included in high-bandwidth memories (HBMs). For example, if the wiring width is 2 µm, the wiring height is 2 µm, and the thickness of each insulating layer is 2 µm, the thickness of the layer formed of an insulating layer and a conductor layer is 4 µm. When two such layers each formed of an insulating layer and a conductor layer are laminated and if the conductor layers 152A and 152D each have a thickness of 10 µm, the thickness of the laminate formed of the wiring board 15 and the conductor layers 152A and 152D will be 28 µm. Thus, the laminate formed of the wiring board 15 and the conductor layers 152A and 152D may be thin.

Fig. 24 is a schematic cross-sectional view illustrating a wiring board 1 with support omitting the wiring board 15, the outermost surface insulating layer 16, the surface treatment layer 17, and the first metal bumps 18 from the wiring board 1 with support described above. Fig. 25 is a schematic plan view illustrating a release layer 13-side surface of the wiring board 1 with support illustrated in Fig. 24.

As shown in Figs. 24 and 25 the outline of the first orthogonal projection of the release layer 13 onto the plane parallel to the support surface of the support 11 is preferred to be inside the outline of the second orthogonal projection of the light absorption layer 12 onto the plane. If the outline of the first orthogonal projection is inside the outline of the second orthogonal projection, heat generated in the light absorption layer 12 due to laser light irradiation is easily transferred to the entire release layer 13. Accordingly, the support 11 can be easily separated from the wiring board 15. Therefore, for example, in the case where the wiring board 15 is transferred to an FC-BGA board using the wiring board 1 with support to obtain a composite wiring board, composite wiring boards can be obtained with high productivity.

According to an example, the structure shown in Figs. 24 and 25 can be obtained by forming a release layer 13 and then removing the peripheral portion of the release layer 13. According to another example, the structure shown in Figs. 24 and 25 can be obtained by forming a light absorption layer 12, then forming a protective film on the peripheral portion of the light absorption layer 12, then forming a release layer 13 on the light absorption layer 12 and the protective film, and then removing the protective film to remove the peripheral portion of the release layer 13 on the protective film.

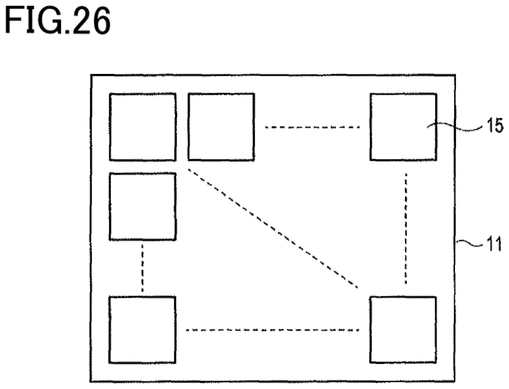

Fig. 26 is a schematic plan view illustrating a wiring board 1 with support omitting the outermost surface insulating layer 16, the surface treatment layer 17, and the first metal bumps 18 from the wiring board 1 with support described above. Fig. 26 shows the wiring board 15-side surface of the wiring board 1 with support. As shown in Fig. 26, a plurality of wiring boards 15 may be provided to the wiring board 1 with support. The plurality of wiring boards 15 may form a board unit, for example.

### <Method of producing composite wiring board>

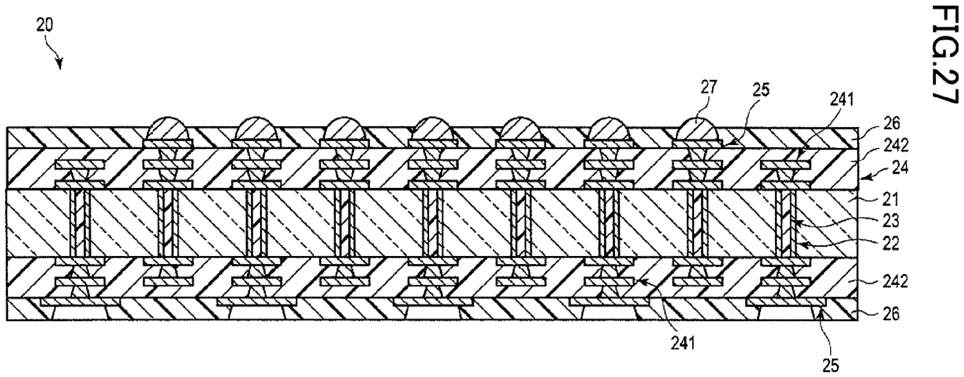

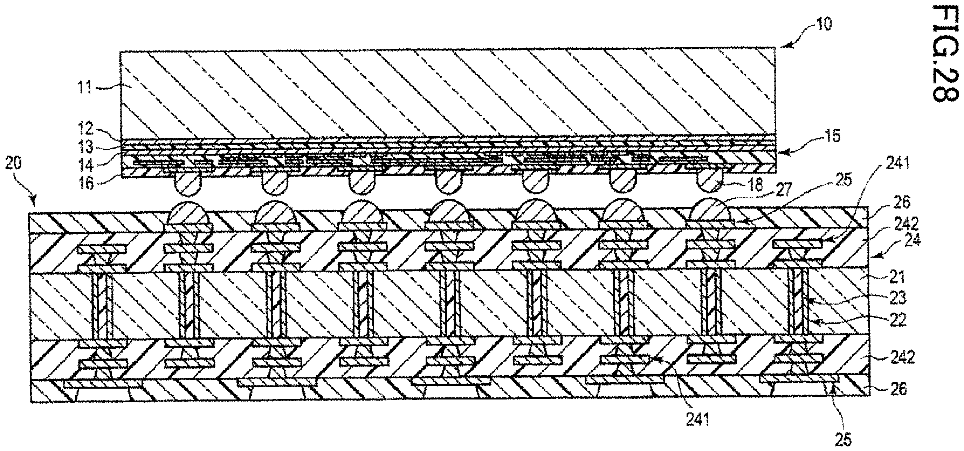

Referring to Figs. 27 to 31, an example of a method of producing a composite wiring board will be described. It should be noted that the surface treatment layer 17 is omitted from Figs. 28 to 32.

First, a first wiring board 20 shown in Fig. 27 is prepared. The first wiring board 20 includes a core layer 21, a conductor material 22, an insulating resin 23, a layer 24, electrodes 25, an outermost surface insulating resin layer 26, and second metal bumps 27. The first wiring board 20 may be an FC-BGA board, for example.

The core layer 21 is an insulating layer. The core layer 21 may be, for example, a fiber-reinforced substrate obtained by impregnating a thermosetting insulating resin in a woven or non-woven fabric. As the woven or non-woven fabric, for example, glass fibers, carbon fibers, or aramid fibers can be used. As the insulating resin, epoxy resins can be used, for example.

The core layer 21 is provided with one or more through holes. The side walls of the through holes are covered with the conductor material 22 containing metals such as copper. The through holes covered with the conductor material 22 are filled with the insulating resin 23.

The support surfaces of the core layer 21 are provided with respective layers 24. The layers 24 each include conductor patterns 241 and an insulating layer 242. The conductor patterns 241 are in contact with the conductor material 22. The insulating layer 242 may cover, for example, the side surfaces of the conductor patterns 241.

In the conductor patterns 241, portions that are not covered with the insulating layer 242 and are not in contact with the core layer 21 are provided with respective electrodes 25.

The line/space in each layer 24 may be, for example, in the range of 8 µm/8 µm to 25 µm/25 µm.

On one major surface side of the core layer 21, the second metal bumps 27 are provided on the respective electrodes 25. On this major surface side, the outermost surface insulating resin layer 26 covers the surface of the layer 24, the side surfaces of the electrodes 25, and part of the second metal bumps 27.

The arrangement of the second metal bumps 27 may be similar, for example, to the arrangement of the first metal bumps 18 provided to the wiring board 1 with support shown in Fig. 9.

As materials of the second metal bumps 27, the materials described for the first metal bumps 18 of the wiring board 1 with support can be used.

On the other major surface side of the core layer 21, an outermost surface insulating resin layer 26 is provided to the surfaces of the electrodes 25 and the surface of the layer 24, with part of the surfaces of the electrodes 25 exposed.

Next, as shown in Fig. 28, the first wiring board 20 is aligned with the wiring board 1 with support shown in Fig. 9. The alignment between the first wiring board 20 and the wiring board 1 with support is performed so that the second metal bumps 27 provided to the first wiring board 20 align with the respective first metal bumps 18 provided to the wiring board 1 with support shown in Fig. 9.

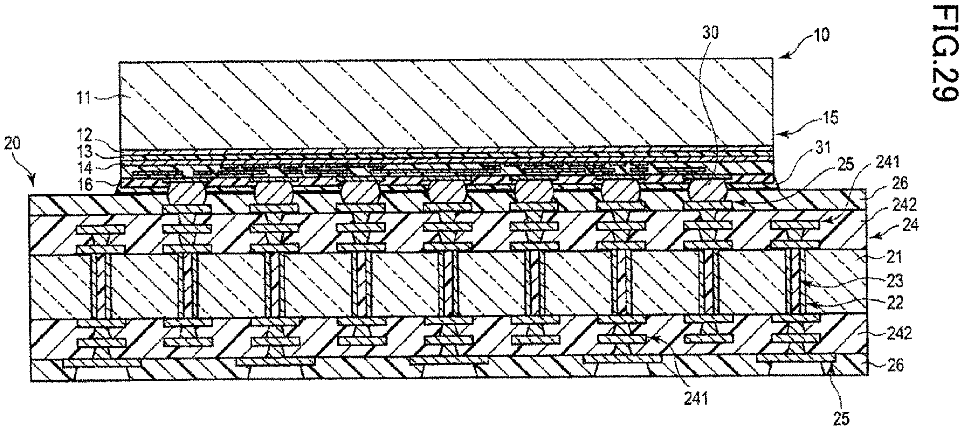

Next, as shown in Fig. 29, the first wiring board 20 is bonded to the wiring board 15 as a second wiring board included in the wiring board 1 with support, and then a first underfill 31 is filled in portions between the first wiring board 20 and the wiring board 1 with support.

For example, the first wiring board 20 and the wiring board 1 with support are bonded together so as to face each other. Specifically, the first wiring board 20 is bonded to the wiring board 1 with support so as to face the wiring board 15-side surface of the wiring board 1 with support.

The bonding is performed via the second metal bumps 27 provided to the first wiring board 20 and the first metal bumps 18 provided to the wiring board 1 with support. Through this bonding, first joints 30 are formed.

The material that can be used for the underfill 31 may be, for example, a mixture of one or more resins selected from the group consisting of epoxy resins, urethane resins, silicone resins, polyester resins, oxetane resins, and maleimide resins, with a filler such as silica, titanium oxide, aluminum oxide, magnesium oxide, or zinc oxide.

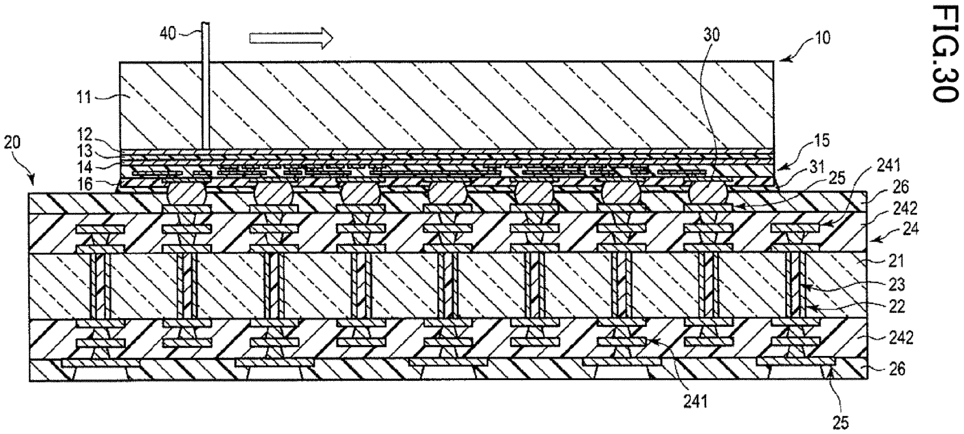

Next, as shown in Fig. 30, laser light 40 is applied to the light absorption layer 12. Specifically, for example, the laser light 40 is applied to the light absorption layer 12 from the support 11-side surface of the composite of the first wiring board 20 and the wiring board 1 with support. The white arrow in Fig. 30 indicates the direction of the laser light 40.

The laser light 40 has a specific wavelength. The specific wavelength is, for example, in the ultraviolet or infrared wavelength region. If the specific wavelength is in the ultraviolet wavelength region, the specific wavelength may be, for example, in the range of 150 nm to 400 nm. If the specific wavelength is in the infrared wavelength region, the specific wavelength may be, for example, in the range of 700 nm to 2,000 nm. The laser light 40 is preferred to be in the infrared wavelength region. The laser light 40 in the infrared wavelength region is less likely to damage the wiring board 15, compared to the laser light 40 in the ultraviolet wavelength region. For example, the conductor layers 152A, 152B, 152C and 152D or the insulating layers 153A, 153B and 153C are prone to defects.

The output of the laser light 40 is preferred to be in the range of 0.05 W to 25 W, and is more preferred to be in the range of 0.1 W to 10 W. If the output of the laser light 40 is in the above range, damage is less likely to occur in the wiring board 15. If the output of the laser light 40 is excessively large, damage tends to occur in the wiring board 15. If the output of the laser light 40 is excessively small, it will be difficult to separate the support 11 from the wiring board 15.

The irradiation energy of the laser light 40 per unit area is preferred to be in the range of 1 mJ/cm² to 1,000 mJ/cm², and is more preferred to be in the range of 10 mJ/cm² to 300 mJ/cm².

The number of times of irradiation of the laser light 40 is preferred to be one. Irradiation may be performed multiple times. From the perspective of processing load, fewer irradiations are preferred.

The light absorption layer 12, when it is irradiated with the laser light 40, generates heat. When the heat generated in the light absorption layer 12 is transferred to the release layer 13, the release layer 13 contacting the light absorption layer 12 is altered at positions of the light absorption layer 12 irradiated with the laser light 40. As a result, adhesion of the release layer 13 decreases.

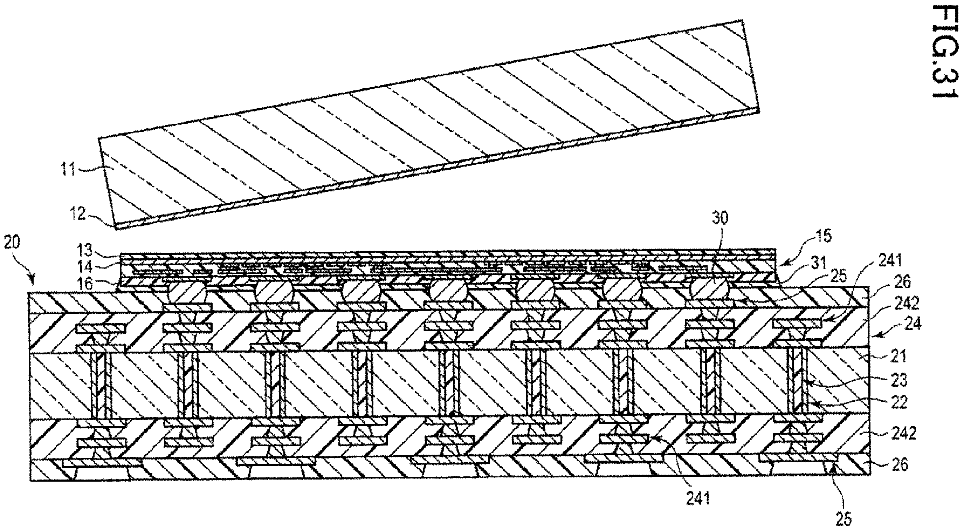

Next, as shown in Fig. 31, the support 11 and the light absorption layer 12 are separated from the wiring board 15.

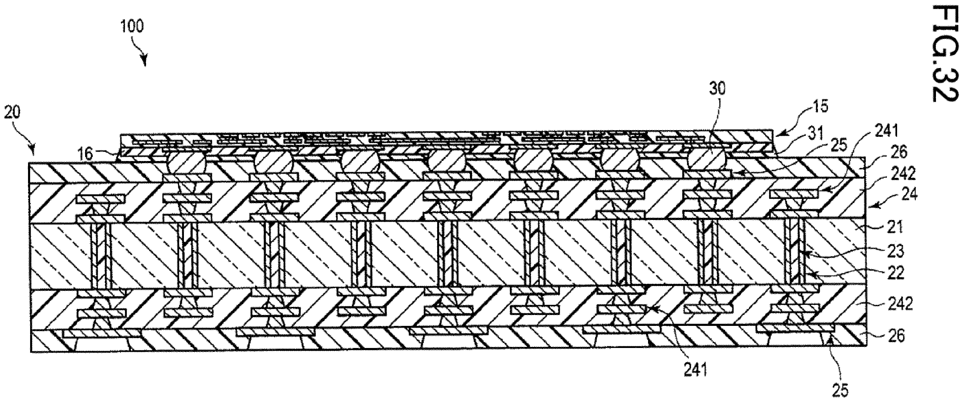

Next, as shown in Fig. 32, the release layer 13 and the first seed layer 14 are removed. If a polyimide resin is used as a material of the release layer 13, the release layer 13 is removed, according to an example, by dry etching using O₂ or CF₂ plasma. According to another example, the release layer 13 is removed using a hydrazine or strong alkaline etching liquid. The release layer 13 is preferred to be removed by dry etching.

If the first seed layer 14 is formed of a first metal-containing layer of titanium and a second metal-containing layer of copper, the first metal-containing layer may be removed, for example, using an alkaline etching agent, and the second metal-containing layer may be removed, for example, using an acid-based etching agent. Thus, a composite wiring board 100 is obtained.

After removing the release layer 13 and the first seed layer 14, a surface treatment layer 17 may be formed on the surface of the conductor layer 152A.

Although separation was caused at the interface between the light absorption layer 12 and the release layer 13 in the method described above, separation may be caused at the interface between the release layer 13 and the first seed layer 14.

The composite wiring board 100 described above can be used, for example, for producing packaged devices. Packaged devices may include, for example, the first wiring board 20, the wiring board 15, and functional devices described above.

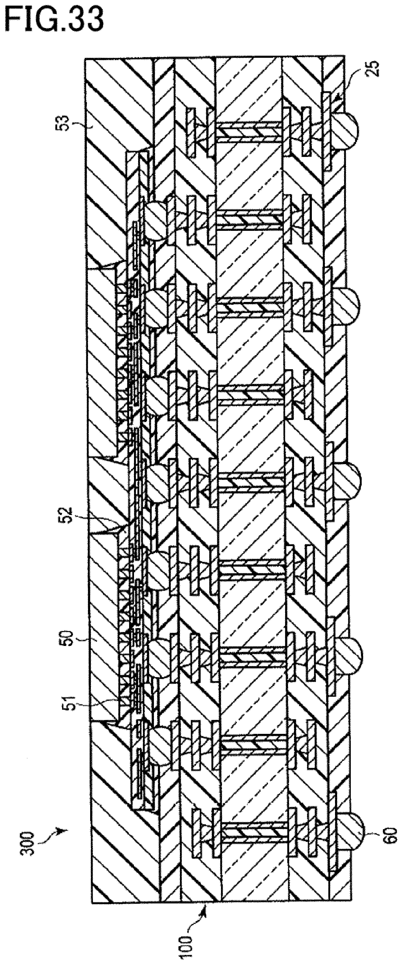

Referring now to Fig. 33, a method of producing a packaged device that uses the composite wiring board 100 will be described.

First, functional devices and the composite wiring board 100 shown in Fig. 32 are prepared.

The functional devices may be, for example, semiconductor chips or chips, such as chips in which circuits or elements are formed on a substrate, such as a glass substrate, made of a material other than semiconductor materials. As an example herein, the functional devices are assumed to be semiconductor chips. In other words, the packaged device herein is a semiconductor package.

Next, as shown in Fig. 33, the composite wiring board 100 and functional devices 50 are bonded together. For example, the functional devices 50 and the composite wiring board 100 are bonded together so as to face each other. Specifically, the functional devices 50 are bonded to the composite wiring board 100 so as to face the wiring board 15-side surface of the composite wiring board 100.

The functional devices 50 are bonded to the composite wiring board 100 via second joints 51. Specifically, the functional devices 50 are bonded to the conductor layer 152D via the second joints 51. Herein, the functional devices 50 are bonded to the composite wiring board 100 using flip chip bonding. One or more functional devices 50 may be bonded to the composite wiring board 100 using other bonding methods such as wire bonding.

The second joints 51 are arrayed at a narrow pitch between each functional device 50 and the composite wiring board 100. The second joints 51 may be, for example, pillars made of copper, or solders. If the functional devices 50 are bonded to the composite wiring board 100 using wire bonding, the functional devices 50 and the composite substrate 100 can be electrically connected using gold wires.

Next, as shown in Fig. 33, a second underfill 52 is filled in portions between the functional devices 50 and the composite wiring board 100. Materials of the second underfill 52 may be similar, for example, to the materials described for the first underfill 31.

Next, as shown in Fig. 33, the functional devices are sealed using a sealing resin 53. The material that can be used for the sealing resin 53 may be, for example, a mixture of one or more resins selected from the group consisting of epoxy resins, urethane resins, silicone resins, polyester resins, oxetane resins, and maleimide resins, with a filler such as silica, titanium oxide, aluminum oxide, magnesium oxide, and zinc oxide. The material of the sealing resin 53 is preferred to be different from the material of the second underfill 52. The sealing resin 53 can be formed using, for example, compression molding or transfer molding.

As shown in Fig. 33, third metal bumps 60 are formed in the regions where the electrodes 25 are exposed on the surface of the first wiring board 20 of the composite wiring board 100. The third metal bumps 60 are used, for example, for bonding to a mother board. Materials of the third metal bumps 60 may be similar, for example, to the materials described for the first metal bumps 18. Thus, a packaged device 300 is obtained.

As shown in Fig. 33, the intervals between the first joints 30 are preferred to be narrower than the intervals between the groups of the second joints 51. In this case, the wiring board 15 can be easily bonded to the functional devices 50 and the first wiring board 20.

Although Fig. 33 shows that the side surfaces of the wiring board 15 are covered with the sealing resin 53, these side surfaces do not have to be covered with the sealing resin 53. In addition, although Fig. 33 shows that the packaged device 300 includes multiple functional devices 50, the number of devices included in the packaged device 300 may be only one.

### <Method of producing functional device-equipped wiring board>

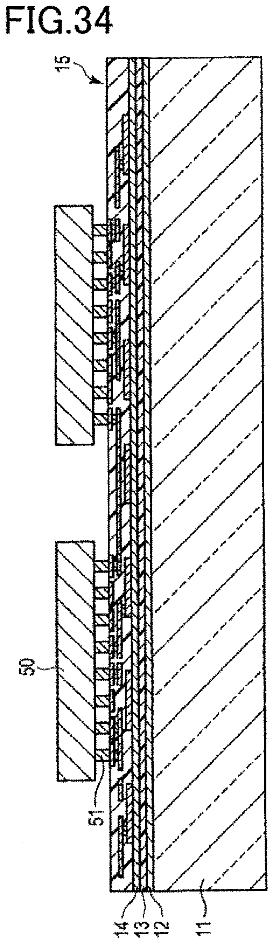

Referring to Figs. 34 to 39, an example of a method of producing a functional device-equipped wiring board will be described. It should be noted that the outermost surface insulating layer 16 and the surface treatment layer 17 are omitted from Figs. 34 to 39.

First, the wiring board 1 with support shown in Fig. 32 and functional devices are prepared.

Next, as shown in Fig. 34, the functional devices 50 are bonded to the wiring board 1 with support shown in Fig. 32. For example, the functional devices 50 and the wiring board 1 with support are bonded together so as to face each other. Specifically, the functional devices 50 are bonded to the wiring board 1 with support so as to face the wiring board 15-side surface of the wiring board 1 with support.

The functional devices 50 are bonded to the wiring board 1 with support via second joints 51. Specifically, the functional devices 50 are bonded to the conductor layer 152D via the second joints 51.

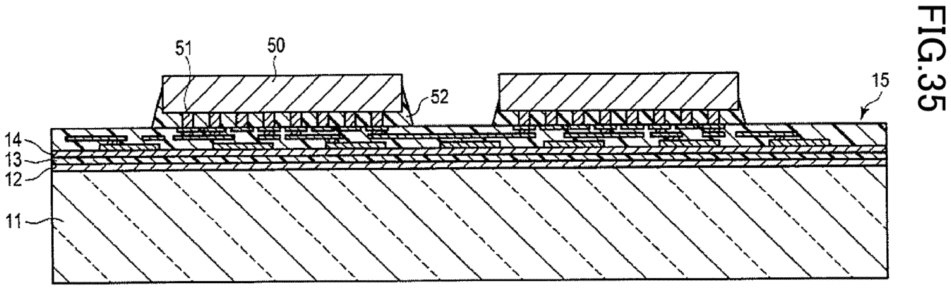

Next, as shown in Fig. 35, a second underfill 52 is filled in portions between the functional devices 50 and the wiring board 1 with support. Filling these portions with the second underfill 52, the functional devices 50 are fixed to the wiring board 1 with support and the second joints 51 are sealed.

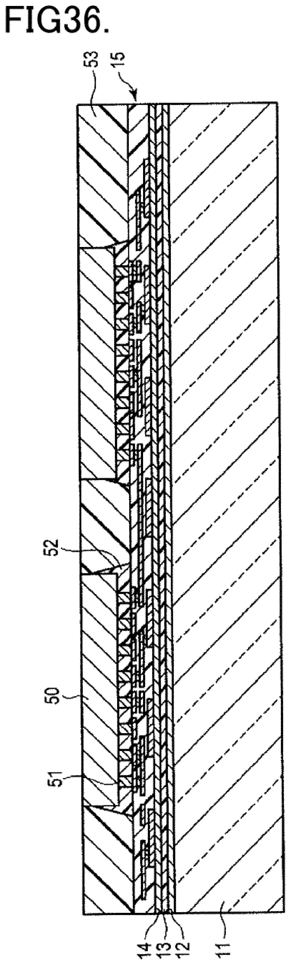

Next, as shown in Fig. 36, the functional devices 50 are sealed with a sealing resin 53.

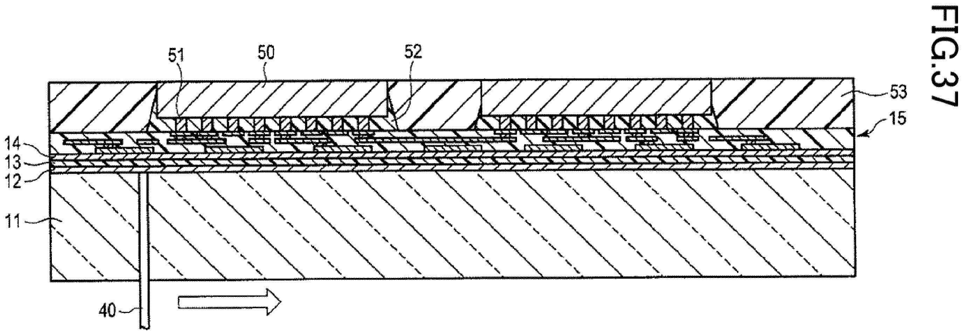

Next, as shown in Fig. 37, laser light 40 is applied to the light absorption layer 12. Specifically, for example, the laser light 40 is applied to the light absorption layer 12 from the support 11-side surface of the composite of the functional devices 50 and the wiring board 1 with support. The white arrow in Fig. 37 indicates the direction of the laser light 40.

The laser light 40 has a specific wavelength. The specific wavelength is, for example, in the ultraviolet or infrared wavelength region. If the specific wavelength is in the ultraviolet wavelength region, the specific wavelength may be, for example, in the range of 150 nm to 400 nm. If the specific wavelength is in the infrared wavelength region, the specific wavelength may be, for example, in the range of 700 nm to 2,000 nm.

The output of the laser light 40 is preferred to be in the range of 0.05 W to 25 W, and is more preferred to be in the range of 0.1 W to 10 W.

The irradiation energy of the laser light 40 per unit area is preferred to be in the range of 1 mJ/cm2 to 1,000 mJ/cm2, and is more preferred to be in the range of 10 mJ/cm2 to 300 mJ/cm2.

The number of times of irradiation of the laser light 40 is preferred to be one. Irradiation may be performed multiple times.

As described above, when the light absorption layer 12 is irradiated with the laser light 40, adhesion of the release layer 13 decreases.

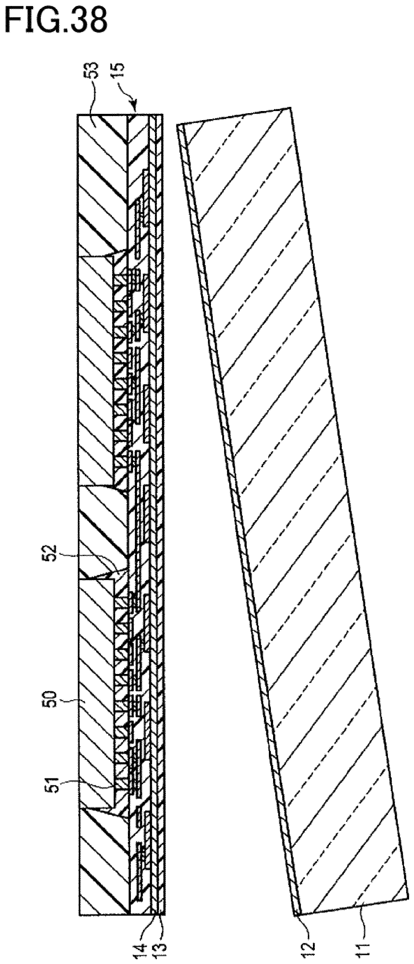

Next, as shown in Fig. 38, the support 11 and the light absorption layer 12 are separated from the wiring board 15.

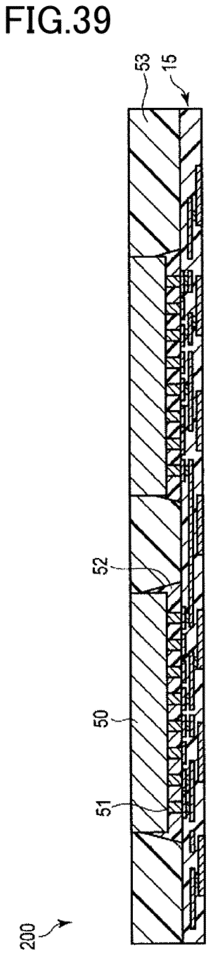

Next, as shown in Fig. 39, the release layer 13 and the first seed layer 14 are removed. Thus, a functional device-equipped wiring board 200 is obtained.

Instead of filling the second underfill 52 in the portions between the functional devices 50 and the wiring board 1 with support after bonding the functional devices 50 to the wiring board 1 with support, an anisotropically conductive film (ACF) may be bonded on wiring board 1 with support and then the functional devices 50 may be bonded to the wiring board 1 with support. Instead of the anisotropically conductive film, a non-conductive film (NCF) may be used. Instead of filling the second underfill 52 in the portions between the functional devices 50 and the wiring board 1 with support after bonding the functional devices 50 to the wiring board 1 with support, a non-conductive paste (NCP) may be applied onto the wiring board 1 with support and then the functional devices 50 may be bonded to the wiring board 1 with support.

After removing the release layer 13 and the first seed layer 14, a surface treatment layer 17 may be formed on the surface of the conductor layer 152A. In addition, although the functional device-equipped wiring board 200 includes multiple functional devices 50 in the method described above, the number of functional devices 50 included in the functional device-equipped wiring board 200 may be only one.

The functional device-equipped wiring board 200 described above can be used, for example, for producing packaged devices. Hereinafter, an example of a method of producing a packaged device that uses the functional device-equipped wiring board 200 will be described.

First, a functional device-equipped wiring board 200 shown in Fig. 39 is prepared.

Next, a surface treatment layer 17 is formed on the surface of the conductor layer 152A included in the functional device-equipped wiring board 200.

Next, first metal bumps 18 are formed on the surface treatment layer 17.

Next, a first wiring board 20 as shown in Fig. 27 is prepared, and the second metal bumps 27 of the first wiring board 20 and the first metal bumps 18 are bonded together.

Next, a first underfill 31 is filled in portions between the first wiring board 20 and the functional device-equipped wiring board 200.

Next, third metal bumps 60 are formed in the regions where the electrodes 25 are exposed on the surface of the first wiring board 20.

Thus, a packaged device 300 is obtained. The surface treatment layer 17 formed on the conductor layer 152A may be omitted.

In the case where the light absorption layer 12 is omitted from the wiring board 1 with support, in order to separate the support 11 from the wiring board 15, laser light in the ultraviolet wavelength region is required to be applied multiple times to the release layer 13 and cause alteration therein that is sufficient to decrease adhesion of the release layer 13. However, if laser light having high energy density, such as laser light in the ultraviolet wavelength region, is applied, the wiring board 15 tends to be damaged. Also, in this case, a high output laser device is required to be used.

In the case where the light absorption layer 12 is omitted from the wiring board 1 with support described above, even if laser light having relatively low energy density, such as laser light in the infrared wavelength region, is applied to the release layer 13, alteration that is sufficient to decrease adhesion of the release layer 13 is less likely to occur.

Furthermore, in the case where the order of laminating the light absorption layer 12 and the release layer 13 is reversed in the wiring board 1 with support described above, the light absorption layer 12 and the release layer 13 tend to remain on the surface of the first seed layer 14 in the process of producing a composite wiring board 100. In this case, the light absorption layer 12 is required to be removed in addition to the removal of the release layer 13 and the first seed layer 14.

However, the wiring board 1 with support described above is provided with the light absorption layer 12, which exhibits higher light absorbance than the release layer, between the release layer 13 and the support 11. Such a light absorption layer 12 generates heat more easily than the release layer 13 due to laser light irradiation. Therefore, compared to the case where the light absorption layer 12 is omitted, the wiring board 1 with support described above tends to undergo alteration that is sufficient to decrease adhesion of the release layer 13.

Therefore, even when laser light in the infrared wavelength region is used, the wiring board 1 with support described above can easily allow the support 11 to separate from the wiring board 15. In this case, the wiring board 15 is less likely to be damaged.

Furthermore, if laser light in the ultraviolet wavelength region is used, the wiring board 1 with support described above can allow the support 11 to separate from the wiring board 15 under moderate irradiation conditions, e.g, shorter irradiation time and lower output, compared to the wiring board with support from which the light absorption layer 12 is omitted. In this case also, the wiring board 15 is less likely to be damaged.

The wiring board 1 with support described above includes the support 11, the light absorption layer 12, and the release layer 13 in this order. Therefore, as shown in Fig. 31, the release layer 13 may remain on the surface of the first seed layer 14 in the process of producing a composite wiring board 100. Alternatively, no layer may remain on the surface of the first seed layer 14. In these cases, the process of removing the light absorption layer 12 is not necessary. Therefore, the number of times of etching can be reduced after separation of the support 11.

In the wiring board 1 with support described above, the laser light 40 reaches the light absorption layer 12 without passing through the release layer 13 and, therefore, the laser light cannot be absorbed by the release layer 13 before the laser light 40 reaches the light absorption layer 12.

In the wiring board 1 with support described above, the light absorption layer 12 is preferred to be in contact with the release layer 13. If the light absorption layer 12 and the release layer 13 are in contact with each other, heat generated due to laser light 40 is easily transferred to the release layer 13 and thus the support 11 can be easily separated from the wiring board 15.

In the wiring board 1 with support described above, the support 11 is preferred to be in contact with the light absorption layer 12. If the support 11 and the light absorption layer 12 are in contact with each other, the support 11 can be easily separated from the wiring board 15 due to a large amount of heat being generated in the light absorption layer 12.

Using the wiring board 1 with support described above, the support 11 can be easily separated from the wiring board 15 in the methods of producing the composite wiring board 100, the functional device-equipped wiring board 200, and the packaged device 300. If laser light in the infrared wavelength region or in the ultraviolet wavelength region is used in these methods, the wiring board 15 is less likely to be damaged.

As mentioned above, there is a technique of providing a silicon interposer containing a silicon wafer between an FC-BGA board and semiconductor chips. In this technique, since usable shape and size of silicon wafers are limited, the number of interposers that can be produced from one silicon wafer is small. Also, since the silicon wafer manufacturing equipment is expensive, silicon interposers are also expensive. In addition, silicon wafers, which are made of semiconductor materials, have high resistance. Therefore, silicon interposers can have degraded transmission characteristics.

In the method of directly forming a multilayer wiring layer in an FC-BGA board using chemical mechanical polishing (CMP) or the like, productivity of the FC-BGA boards is low, although degradation of the transmission characteristics is low. In addition, it is very difficult to form fine wiring on FC-BGA boards. Therefore, productivity tends to become low in the above method. Also, there may be raised issues related to mounting of semiconductor chips due to warpage or strain of FC-BGA boards.

The wiring board with support, the method of producing a wiring board with support, the method of producing a composite wiring board, and the method of producing a functional device-equipped wiring board according to the present embodiment are as follows.

[1] A wiring board with support comprising
   a support having a support surface and transmitting light with a specific wavelength in the direction perpendicular to the support surface;
   a wiring board facing the support surface;
   a release layer that is interposed between the support and the wiring board and decreases adhesion in response to heating; and
   a light absorption layer interposed between the support and the release layer, wherein
   the light absorption layer exhibits higher light absorbance than the release layer.
[2] The wiring board with support according to [1], wherein the light absorption layer has a thickness in the range of 5 nm to 100 nm.
[3] The wiring board with support according to [1] or [2], wherein the release layer has a thickness in the range of 10 nm to 50 µm.
[4] The wiring board with support according to any one of [1] to [3], wherein the outline of a first orthogonal projection of the release layer onto a plane parallel to the support surface is inside the outline of a second orthogonal projection of the light absorption layer onto the plane.
[5] The wiring board with support according to any one of [1] to [4], wherein the light absorption layer contains a metal, and the release layer contains a resin.
[6] The wiring board with support according to any one of [1] to [5], wherein the wiring board is a multilayer wiring board.
[7] The wiring board with support according to [6], wherein the multilayer wiring board is an interposer.
[8] A wiring board with support comprising
   a support having a support surface and transmitting light with a specific wavelength in the direction perpendicular to the support surface;
   a wiring board facing the support surface;
   a release layer that is interposed between the support and the wiring board and decreases adhesion in response to heating; and
   a light absorption layer interposed between the support and the release layer, wherein
   the light absorption layer contains one or more metals selected from the group consisting of titanium, chromium, tungsten, nickel, molybdenum, niobium, and tantalum.
[9] A method of producing a wiring board with support, comprising steps of:
   forming a light absorption layer on a support that has a support surface and transmits light with a specific wavelength in the direction perpendicular to the support surface;
   forming a release layer that decreases adhesion in response to heating on the light absorption layer; and
   forming a wiring board on the release layer, wherein
   the light absorption layer exhibits higher light absorbance than the release layer.
[10] A method of producing a composite wiring board, comprising steps of:
   bonding a first wiring board to the wiring board as a second wiring board that is included in the wiring board with support according to any one of [1] to [8]; and
   irradiating the light absorption layer with laser light having the specific wavelength to separate the support from the wiring board.
[11] The method of producing a composite wiring board according to [10], wherein
   the laser light is applied to the light absorption layer from the support side; and
   the specific wavelength is in the infrared wavelength region.
[12] A method of producing a functional device-equipped wiring board, comprising steps of:
   bonding functional devices to the wiring board with support according to any one of [1] to [8]; and
   irradiating the light absorption layer with laser light having the specific wavelength to separate the support from the wiring board.
[13] The method of producing a functional device-equipped wiring board according to [12], wherein
   the laser light is applied to the light absorption layer from the support side; and
   the specific wavelength is in the infrared wavelength region.

### <Fourth Embodiment>

The method in which a fine wiring layer is formed on a support and this is mounted to an FC-BGA board has suffered from the following issues. Specifically, there has been an issue that, when separating a support substrate after forming a fine wiring layer thereon and mounting it to an FC-BGA board, the sealing resin material used when mounting the fine wiring layer to the FC-BGA board may rise and wet the support substrate and prevent separation of the support substrate, and an issue that the entire fine wiring layer may warp due to the force generated when separating the support substrate or the internally stored stress, causing problems when mounting semiconductor elements.

There is another method in which a fine wiring layer is formed on a support substrate, and semiconductor elements are mounted on the fine wiring layer and sealed, followed by separating the fine wiring layer from the support substrate, and mounting the separated semiconductor element-equipped fine wiring layer to an FC-BGA board. According to this method, the semiconductor elements can be mounted with smaller deformation because the semiconductor elements are mounted on the fine wiring layer supported by the support substrate. However, since the fine wiring layer is formed on one surface of a support, there has been an issue that warpage may occur due to the thermal history when forming the wiring layer. In particular, since semiconductor elements mounted on fine wiring layers have terminals with short intervals therebetween, they have suffered from an issue that mounting failures tend to occur due to only small warpage that had occurred in the fine wiring layers.

To cope with these issues, the present embodiment has an aim to provide a board unit that is less likely to deform and can be stably produced, a method of producing a board unit, and a method producing a semiconductor device.

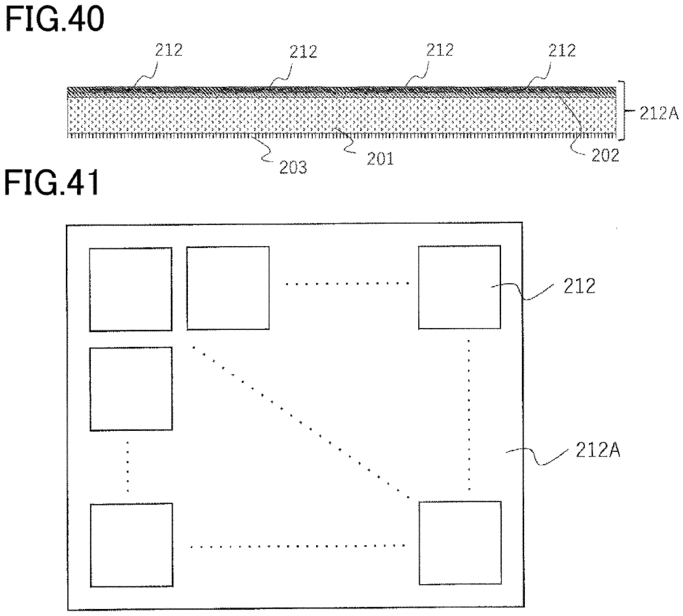

First, as shown in Fig. 40, an example of using a rectangular plate-like member as a support 201 will be described. Fig. 40 is a cross-sectional view illustrating a state in which a release layer 202 is formed on the upper surface of a support 201, a plurality of first wiring boards 212 are formed on the upper surface of the release layer 202, and a warp-suppression layer 203 is formed on the lower surface of the support 201.

In the present embodiment, as shown in Fig. 41, a plurality of first wiring boards 212 are disposed on the support 201 to form a board unit 212A.

The support 201 described in the present embodiment is a panel that is a rectangular plate-like member. However, the support 201 may be, for example a circular wafer.

It is advantageous that the support 201, through which the release layer 202 may be irradiated with light, has translucency and is formed of glass, for example. Since rectangular glass is suitable for upsizing and has good flatness and high rigidity, it is suitable for forming fine patterns thereon.

In addition, glass has a low coefficient of thermal expansion (CTE) and is resistant to strain and therefore is excellent in securing pattern placement accuracy and flatness. If glass is used as the support 201, the thickness of the glass is preferred to be large, e.g., 0.7 mm or more, and more preferred to be 1.1 mm or more, from the perspective of suppressing the occurrence of warpage in the production process.

Furthermore, CTE of the glass is preferred to be 3 ppm or more and 15 ppm or less, and is more preferred to be around 9 ppm, from the perspective of consistency with CTEs of the FC-BGA board (second wiring board) 12 and semiconductor elements 211.

As types of the glass, for example, quartz glass, borosilicate glass, non-alkali glass, soda glass, sapphire glass, and the like can be used.

However, if the support 201 is not required to have translucency when separating the support 201, such as the case where a resin that foams due to heat is used as the release layer 202, the support 201 can be formed using metal or ceramics, for example, inducing less strain.

The release layer 202 may be, for example, a resin which becomes separable due to heat generation as a result of absorbing light such as UV light or due to alteration, or a resin which becomes separable due to foaming as a result of being heated.

Specifically, the material of the release layer 202 can be selected, for example, from organic resins such as epoxy resins, polyimide resins, polyurethane resins, silicone resins, polyester resins, oxetane resins, maleimide resins, and acrylic resins, or from inorganic layers such as an amorphous silicon layer, a gallium nitride layer, and metal oxide layers. The material of the release layer 202 may contain additives such as photolysis accelerants, light absorbers, sensitizers, and fillers.

The release layer 202 may be formed of a plurality of layers. For example, a protective layer may be provided on the release layer 202 for the purpose of protecting the multilayer wiring layer formed on the support 201 in the later process, or a layer that enhances adhesion to the support 201 may be provided as an underlayer of the release layer 202. Furthermore, a laser light reflective layer or a metal layer may be provided between the release layer 202 and the multilayer wiring layer, and thus the structure of the release layer 202 should not be limited by the present embodiment.

If a resin that becomes separable due to light such as laser light is used as the release layer 202 and if the support 201 has translucency, light may be applied to the release layer 202 from the surface of the support 201 facing away from the surface provided with the release layer 202, i.e., the surface on which the warp-suppression layer 203 is formed.

The warp-suppression layer 203 may be, for example, a resin that transmits light such as laser light. Specifically, examples of the material that can be used for the warp-suppression layer 203 include organic resins such as epoxy resins, polyimide resins, polybenzoxazole resins, and benzocyclobutene resins. The warp-suppression layer 203 can be made a resin that is the same as the insulating resin used for the first wiring boards 212, and the resin may have photosensitivity.

The warp-suppression layer 203 is preferred to have a thickness of 5 µm or more and 50 µm or less. If the thickness is 5 µm or less, no warp suppression effect can be achieved. If the thickness is 50 µm or more, the warp suppression effect becomes excessive and warpage may occur in the opposite direction. The thickness of the warp-suppression layer 203 is preferred to be smaller than that of the first wiring boards. If the warp-suppression layer 203 is thicker than the first wiring boards 212, the warp suppression effect may become excessive and warpage may occur in the opposite direction (deviation toward the first wiring boards 212 may occur).

Hereinafter, an embodiment of the present invention will be described taking an example in which a resin that transmits IR (infrared) laser light is used for the warp-suppression layer 203, glass is used for the support 201, and a resin that becomes separable due to absorption of IR laser light is used for the release layer 202.

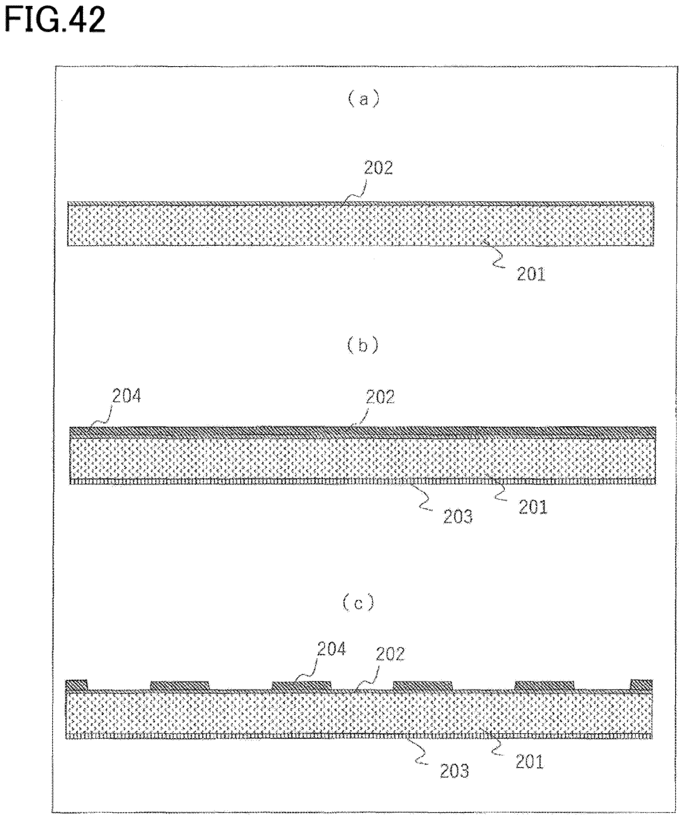

Referring to Figs. 42 to 47, an example of a process of producing first wiring boards 212 on a support 201 according to an embodiment of the present invention will be described.

First, as shown in Fig. 42(a), a release layer 202 is formed on the support 201.

Next, as shown in Fig. 42(b), an insulating resin layer 204 is formed on the release layer 202, and a warp-suppression layer 203 is formed on the lower surface of the support 201.

The insulating resin layer of the present embodiment may be formed, for example, by spin-coating a photosensitive epoxy resin. Photosensitive epoxy resins can be cured at relatively low temperatures, and are less likely to shrink due to curing after formation, and thus exhibits good fine pattern formability thereafter.

The method of forming a photosensitive resin in the case of using a liquid photosensitive resin can be selected from slit coating, curtain coating, die coating, spray coating, electrostatic coating, inkjet coating, gravure coating, screen printing, gravure offset printing, spin coating, and doctor coating. In the case of using a film-like photosensitive resin, lamination, vacuum lamination, vacuum pressing, or the like can be applied. Examples of the material that can be used for the insulating resin layer include photosensitive polyimide resins, photosensitive benzocyclobutene resins, photosensitive epoxy resins, denatured products thereof, and photosensitive polybenzoxazole resins.

The method of forming the warp-suppression layer 203 in the case of using a liquid resin can be selected from slit coating, curtain coating, die coating, spray coating, electrostatic coating, inkjet coating, gravure coating, screen printing, gravure offset printing, spin coating, and doctor coating. In the case of using a film-like resin, lamination, vacuum lamination, vacuum pressing, or the like can be applied. Examples of the material that can be used for the warp-suppression layer 203 include photosensitive polyimide resins, photosensitive benzocyclobutene resins, photosensitive epoxy resins, denatured products thereof, and photosensitive polybenzoxazole resins.

The warp-suppression layer 203 can be made using a resin that is the same as that of the insulating resin layer 204. Using the same material as that of the insulating resin layer 204, processing in a series of processes can be performed.

Either of the insulating resin layer 204 and the warp-suppression layer 203 may be formed first. After forming a warp-suppression layer 203 on the lower surface of the support 201, a release layer 202 and an insulating resin layer 204 may be formed.

A resin different from that of the insulating resin layer 204 can be used for the warp-suppression layer 203. For example, if a resin having a higher Young's modulus and higher CTE than those of the insulating resin layer 204 is used, a warp suppression effect can be achieved even when the warp-suppression layer 203 is made thin.

The warp-suppression layer 203 may contain a resin different from that of the insulating resin layer 204 of the first wiring boards 212. If the warp-suppression layer 203 contains a resin different from that of the insulating resin layer 204, the number of selectable resins increases and design flexibility is enhanced. For example, a photosensitive epoxy resin can be used for the insulating resin layer 204 of the first wiring boards 212, while a non-photosensitive and thermosetting polyimide resin can be used for the warp-suppression layer 203.

The warp-suppression layer 203 is preferred to have Young's modulus × thickness × CTE that is 0.9 to 1.1 times of that of the insulating resin (insulating resin layer 204) of the first wiring boards. If Young's modulus × thickness × CTE of the warp-suppression layer 203 is less than 0.9 times of that of the insulating resin of the first wiring boards, the warp suppression effect cannot be necessarily achieved. If Young's modulus × thickness × CTE of the warp-suppression layer 203 is more than 1.1 times of that of the insulating resin of the first wiring boards, the warp suppression effect becomes excessive and warpage may occur in the opposite direction.

Young's modulus shows elastic properties of materials and indicates a value of resistance to material deformation. Young's modulus is also referred to as a longitudinal elastic modulus. Young's modulus is obtained through measurement using a universal material testing machine, thin film hardness meter, dynamic viscoelasticity measuring device, etc. Young's modulus of the warp-suppression layer 203 and that of the insulating resin layer 204 are preferred to be values obtained at the same temperature using the same measurement method.

CTE is a length change rate per unit temperature change and is also referred to as a thermal expansion rate or coefficient of linear expansion. CTE is obtained through measurement using a thermal mechanical analyzer, etc. For CTE, an average CTE in some temperature range can be used. CTE of the warp-suppression layer 203 and that of the insulating resin layer 204 are preferred to be values obtained at the same temperature using the same measurement method.

Hereinafter, an embodiment of the present invention will be described taking an example in which the warp-suppression layer 203 is formed with a thickness of 15 µm using a resin that is the same as that of the insulating resin layer 204.

Next, as shown in Fig. 42(c), openings are formed in the insulating resin layer using photolithography. The openings may be subjected to plasma treatment for the purpose of removing residues formed during development. The thickness of the insulating resin layer 204 is determined according to the thickness of the conductor layer portions formed in the openings, and is determined to be 7 µm, for example, in an embodiment of the present invention. The shape of the openings in plan view is determined according to the pitch and shape of the junction electrodes of the FC-BGA board. In an embodiment of the present invention, the openings have a diameter, for example, of ϕ80 µm and are formed at the pitch of 150 µm.

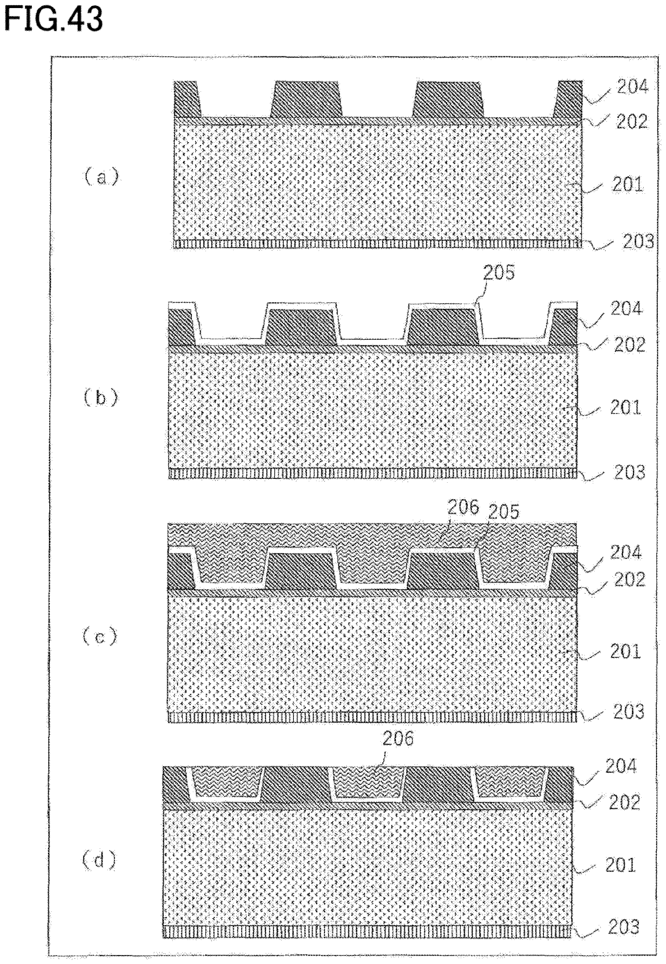

Referring to Figs. 43 to 47, a process of producing first wiring boards 212 on the upper surface of the support 201 will be described. In Figs. 43 to 47, an example of a process of forming multilayer wiring of the first wiring boards of the present invention, and a process of forming junction electrodes will be described using enlarged diagrams showing a part of the center region of the support 201.

In Fig. 43(a), as in Fig. 42(c), a release layer 202 and an insulating resin layer 204 are formed on the upper surface of the support 201, and a warp-suppression layer 203 is formed on the lower surface of the support 201.

Next, as shown in Fig. 43(b), a seed layer 205 is formed on the release layer 202 in a vacuum. The seed layer 205 serves as a power supply layer for electroplating when forming wiring. The seed layer 205 can be formed using, for example, sputtering, CVD, or the like, and examples of the material include Cu, Ni, Al, Ti, Cr, Mo, W, Ta, Au, Ir, Ru, Pd, Pt, AlSi, AlSiCu, AlCu, NiFe, ITO, IZO, AZO, ZnO, PZT, TiN, and Cu₃N₄, which can be used singly or in combination of two or more.

In the present embodiment, a titanium layer and a copper layer are sequentially formed by sputtering, from the perspective of electrical characteristics, ease of preparation, and cost. The total thickness of the titanium layer and the copper layer is preferred to be 1 µm or less as a power supply layer for electroplating. In an embodiment of the present invention, Ti: 50 nm and Cu: 300 nm are used.

Next, as shown in Fig. 43(c), a conductor layer 206 is formed on the seed layer 205 using electroplating. The conductor layer 206 serves later as junction electrodes to the FC-BGA board 213. The electroplating may be of nickel, copper, chromium, Pd, gold, rhodium, iridium, or the like. However, copper electroplating is preferred from the perspective of ease, cost, and electrical conductivity.

The thickness of the copper electroplating is preferred to be 1 µm or more from the perspective that the conductor layer 206 serves as junction electrodes solder-bonded to the FC-BGA board 213, and is preferred to be 30 µm or less from the perspective of productivity. In an embodiment of the present invention, copper electroplating is performed with a thickness of Cu: 9 µm in the openings of the insulating resin layer 204, and with a thickness of Cu: 2 µm on the insulating resin layer 204.

Next, as shown in Fig. 43(d), the copper layer is polished using chemical mechanical polishing (CMP) processing or the like to remove part of the conductor layer 206 and portions of the seed layer 205. In an embodiment of the present invention, Cu: 2µm of the conductor layer 206 and portions of the seed layer 205 on the insulating resin layer 204 are polished away. Thus, the conductor layer 206 portions remaining after the polishing serve as junction electrodes to the FC-BGA board 213. In other words, in the present embodiment, junction electrodes to the FC-BGA board 213 are formed using a damascene method.

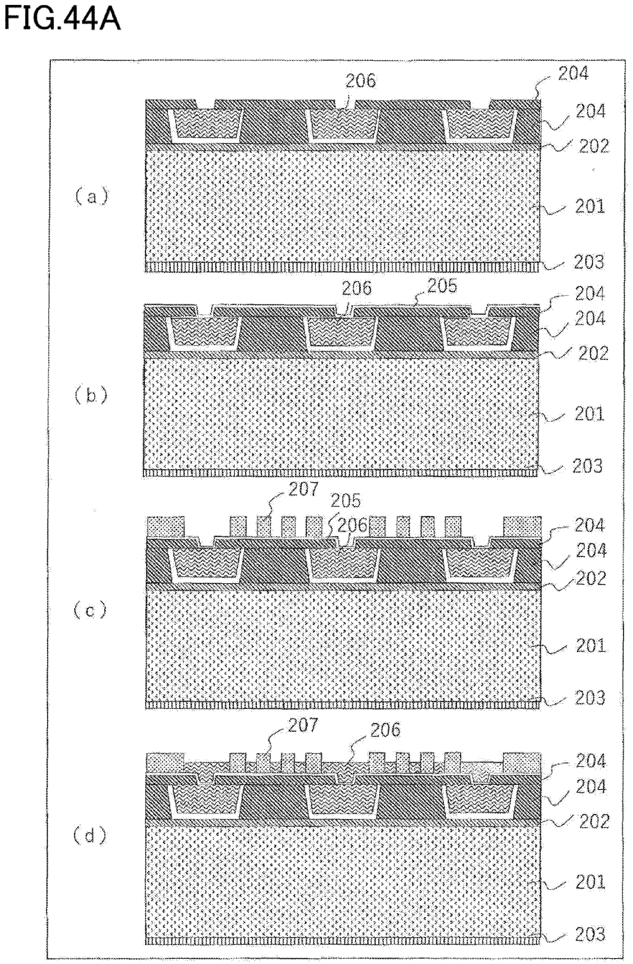

Next, a wiring layer is formed. In an example of the present invention, a wiring layer is formed using semi-additive processing (SAP). First, as shown in Fig. 44A(a), as in Fig. 43(a), insulating resin layer 204 is formed on the planar surface formed in Fig. 43(d). The thickness of the insulating resin layer 204 is determined according to the thickness of the conductor layer formed in the openings, and is determined to be 2 µm, for example, in an embodiment of the present invention.

The openings of the insulating resin layer 204 are formed for connection with the conductor layer 206 portions. In an embodiment of the present invention, the openings are formed, for example, with a diameter of ϕ10 µm. These openings each have a shape of a via connecting between the overlayer and the underlayer of multilayer wiring.

Next, as shown in Fig. 44A(b), as in Fig. 43(b), a seed layer 205 is formed in a vacuum.

Next, as shown in Fig. 44A(c), a first resist pattern 207 is formed on the upper surface of the seed layer 205. After that, as shown in Fig. 44A(d), a conductor layer 206 is formed using electroplating. The conductor layer 206 serves as vias and wiring portions.

The electroplating may be of nickel, copper, chromium, Pd, gold, rhodium, iridium, or the like. However, copper electroplating is preferred from the perspective of ease, cost, and electrical conductivity.

The thickness of copper electroplating is preferred to be 0.5 µm or more from the perspective of electrical resistance of the wiring portions, and is preferred to be 30 µm or less from the perspective of productivity. In an embodiment of the present invention, Cu: 4 µm is formed in the openings of the insulating resin layer 204, and Cu: 2 µm is formed on the insulating resin layer 204.

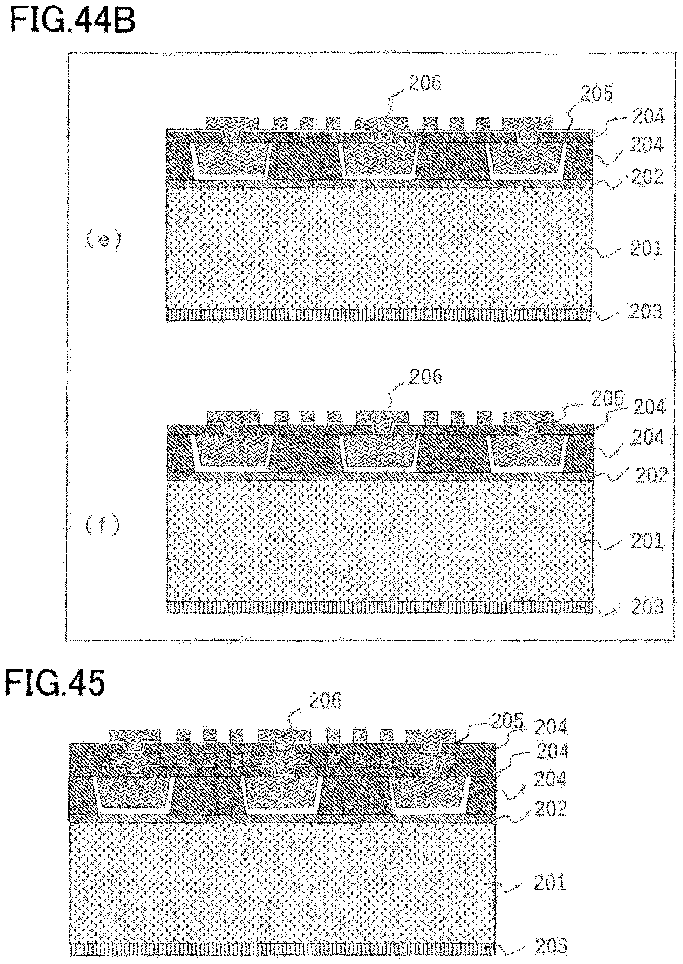

After that, as shown in Fig. 44B(e), the resist pattern 207 is removed. After that, as shown in Fig. 44B(f), unnecessary seed layer 205 portions are etched away.

Repeating the processing of Figs. 44A and 44B, wiring of a multilayer structure can be formed on the release layer 202. Fig. 45 shows an example of a structure in which two wiring layers are formed.

If warpage increases in the board unit due to the multilayering process, the thickness of the warp-suppression layer 203 can be increased as appropriate.

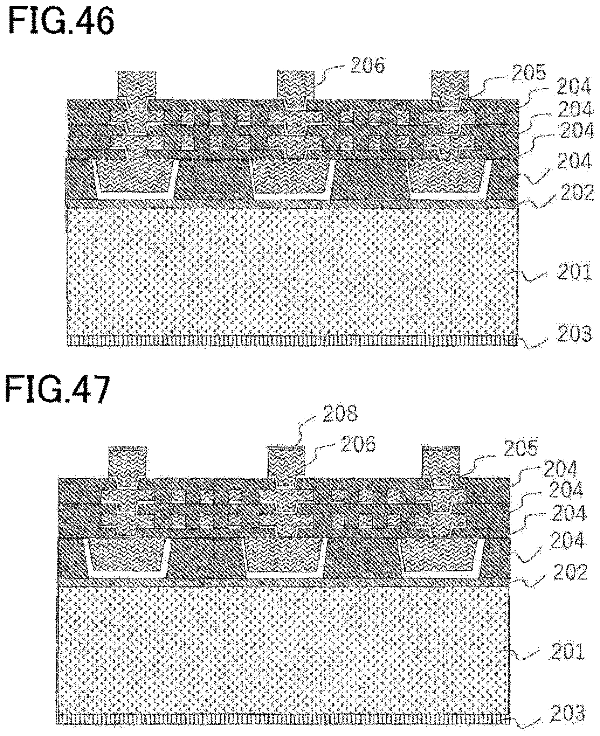

Next, as shown in Fig. 46, a conductor layer 206 is formed for use as junction electrodes to semiconductor elements 211 to provide a board unit. The method of forming the junction electrodes is the same as the method of forming the wiring layer described above; however, the thickness of copper electroplating is different between the junction electrodes and the wiring layer. The thickness of copper electroplating for the junction electrodes is preferred to be 1 µm or more from the perspective of solder bonding, and is preferred to be 30 µm or less from the perspective of productivity. In an embodiment of the present invention, Cu: 9 µm is formed in the openings of the insulating resin layer 204, and Cu: 7 µm is formed on the insulating resin layer 204.

Next, as shown in Fig. 47, a surface treatment layer 208 may be provided to the board unit to prevent oxidation of the surface of the conductor layer 206 and enhance wettability of solder bumps. In an embodiment of the present invention, an Ni/SnAg electroplating film is formed as the surface treatment layer 208. It should be noted that OSP (surface treatment using organic solderability preservative water-soluble preflux) film may be formed as the surface treatment layer 208.

Surface treatment may be appropriately selected according to usage from electroplating of Sn, SnAg, Ni/Sn, Ni/SnAg, Ni/Cu/Sn, Ni/Cu/SnAg, Ni/Au and Ni/Pd/Au, electroless plating of Ni/Au, Ni/Pd/Au and Sn, and the like.

Thus, as shown in Fig. 40, first wiring boards 212 are completed on the support to obtain a board unit 212A in which a plurality of first wiring boards 212 are attached onto the support.

Other than the semi-additive processing (SAP) described referring to Figs. 44 to 47, wiring layers can be achieved using a damascene method. In the case of using a damascene method, lamination of an insulating resin layer is followed by photolithography for forming a pattern, and formation of a seed layer is followed by copper electroplating. After copper electroplating, flattening may be performed using chemical mechanical polishing (CMP). The number of wiring layers is one or more, and may be appropriately determined according to the line width of the first wiring boards.

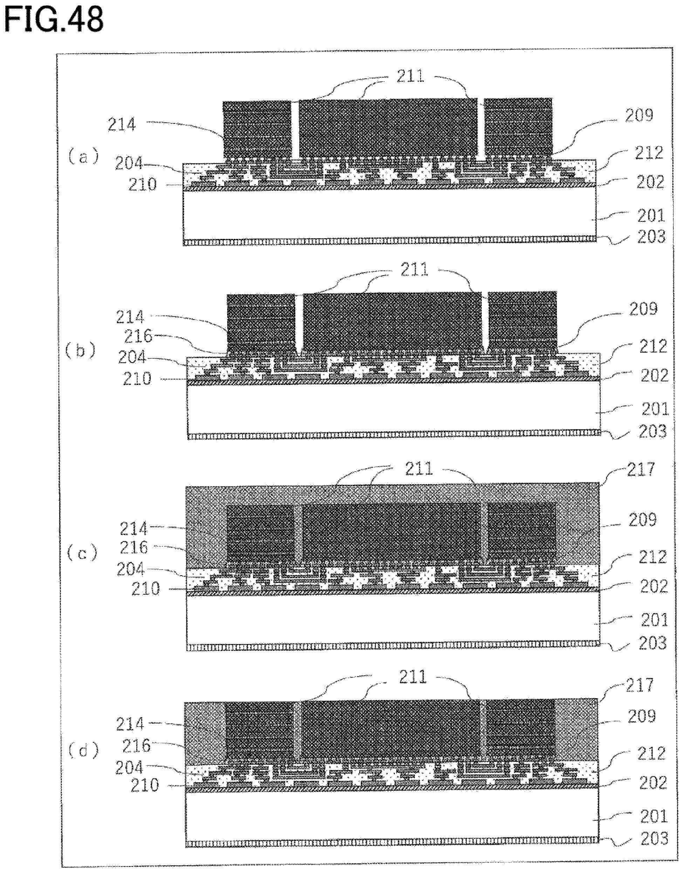

Next, referring to Figs. 48 to 52, a description will be given of an example of a process of mounting semiconductor elements on the wiring board, a process of removing the support and the release layer, and a method of producing a semiconductor device including a process of mounting the semiconductor element-equipped wiring board to an FC-BGA board, according to an embodiment of the present invention. Figs. 48 to 52 are cross-sectional views limited to a region of a first wiring board 212 after segmentation, in order to describe the details of the plurality of first wiring boards disposed on the support 201.

First, a process of mounting semiconductor elements 211 shown in Fig. 48(a) will be described. In Fig. 48(a), 209 represents electrodes for mounting semiconductor elements, 210 represents junction electrodes to an FC-BGA board, 212 represents a first wiring board, and 214 represents solder joints between the semiconductor elements and the first wiring board.

The semiconductor elements 211 are mounted to the first wiring board 212 using mounting and reflowing, thermal compression bonding (TCB), or the like. For TCB, a thermal compression capillary underfill (TC-CUF) method in which a first sealing resin 216 is injected using capillary action after solder bonding, a method using non-conductive film (NCF), a method using non-conductive paste (NCP) in which a liquid resin is placed in advance before bonding to fill spaces when bonding, or the like may be used.

In the present embodiment, the TC-CUF method based on capillary action injection is used, as shown in Fig. 48(b), when sealing the solder joints with the first sealing resin 216. The method of mounting the semiconductor elements 211 may be appropriately changed from the perspective of the size of the semiconductor elements 211, and the equipment used for mounting. However, if the bonding pitch between the first wiring board 212 and the semiconductor elements 211 is fine, any of the TCB methods is preferred to be selected.

Next, as shown in Fig. 48(c), the semiconductor elements 211 are sealed with a second sealing resin 217 to protect the side surfaces of the semiconductor elements 211. The material used for the second sealing resin 217 is in the form of granules, liquids or tablets, formulated by adding silica, titanium oxide, aluminum oxide, magnesium oxide, zinc oxide, etc. as a filler, to one of an epoxy resin, silicone resin, acrylic resin, urethane resin, polyester resin, and oxetane resin, or a mixture of two or more of these resins, and is formed using compression molding, transfer molding, or the like. The size, the composition, and the forming method of the resin can be appropriately determined according to the mode of disposition of the first wiring board 212 on the support 201. In the present invention, a liquid epoxy resin is used and the resin is formed using compression molding.

Next, as shown in Fig. 48(d), with respect to the first wiring board 212 sealed with the second sealing resin 217, the second sealing resin 217 on the upper surfaces of the semiconductor elements 211 is removed. If the second sealing resin 217 remains on the semiconductor elements 211, warpage may occur due to CTE of the second sealing resin 217 and, in some cases, separation may occur at the interface between the first wiring board 212 and the second sealing resin 217. The second sealing resin 217 on the semiconductor elements 211 can be removed using CMP, grinding, or the like. In the present invention, the second sealing resin 217 on the semiconductor elements 211 is removed by grinding.

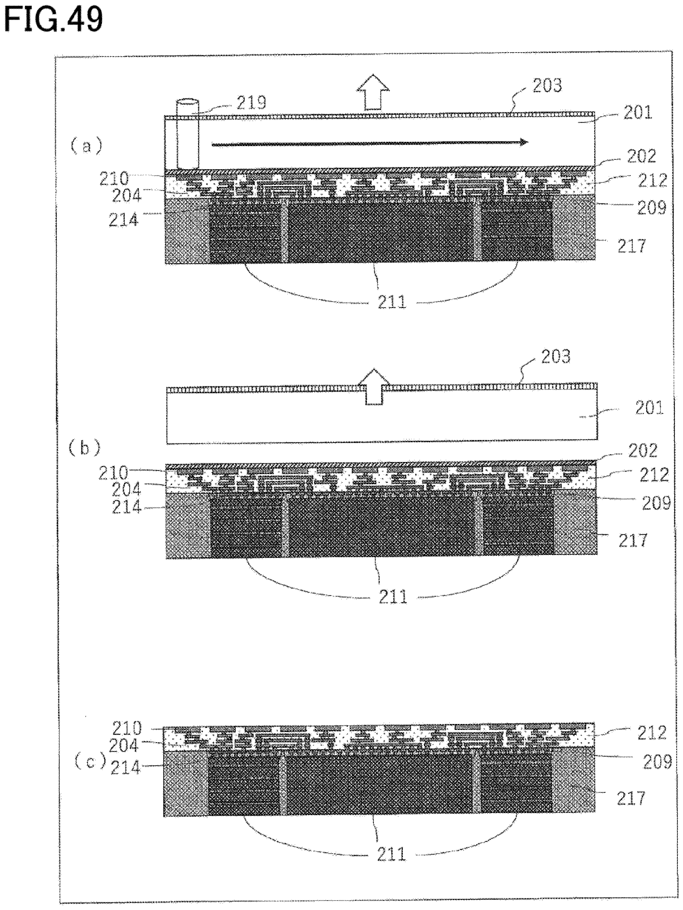

Next, referring to Fig. 49, a process of separating the first wiring board and the semiconductor elements from the support 201 will be described. Fig. 49 shows the segmented support 201 and the first wiring board 212 equipped with the semiconductor elements shown in Fig. 48, with the top and bottom reversed.

If the release layer 202 becomes separable when irradiated with laser light 219, the laser light 219 is applied, as shown in Fig. 49(a), to the warp-suppression layer 203 from the warp-suppression layer 203 side because the support 201 is translucent. The laser light 219 is applied to the release layer 202 via the warp-suppression layer 203 and the support 201, by which, as shown in Fig. 49(b), the support 201 becomes detachable. In an embodiment of the present invention, IR laser light of 1,064 nm was used as the laser light 219. In an embodiment of the present invention, the support 201 is glass and has translucency, while the resin, i.e., epoxy resin, polyimide resin, polybenzoxazole resin, or benzocyclobutene resin, used for the warp-suppression layer 203 has the property of transmitting IR laser, the laser light passes through the warp-suppression layer and the support and is applied to the release layer.

Next, as shown in Fig. 49(c), the release layer 202 is completely removed using dry etching, solvent cleaning, ultrasonic cleaning, or the like to expose the junction electrodes 210 to the FC-BGA board 213. If dry etching is used, the gas used for the etching should contain one or more of O₂, Ar, CF₄ and the like. If solvent cleaning is used, a solvent, such as acetone, toluene, MEK or methanol, is used. If ultrasonic cleaning is used, the removal is performed in the oscillation frequency range of 28 kHz to 1 MHz. The release layer 202 may be removed by combining one or more of these removal methods.

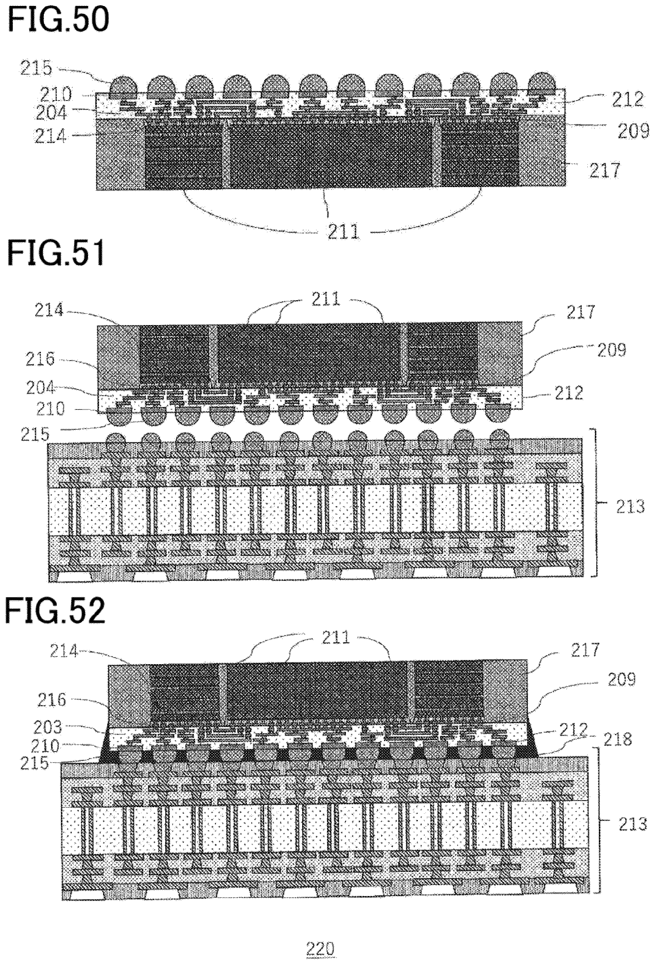

Next, as shown in Fig. 50, solder is formed on the junction electrodes 210 of the first wiring board 212, for bonding to the FC-BGA board 213. The solder can be formed by forming an organic solderability preservative (OSP: surface treatment using preflux) film on the junction electrodes 210 to the FC-BGA board 213, or forming Ni/Au, Ni/Pd/Au or Sn thereon using electroless plating, followed by flux printing, mounting solder balls and reflowing, or forming Sn, SnAg, Ni/Sn, Ni/SnAg, Ni/Cu/Sn, Ni/Cu/SnAg or Sn thereon using electroplating, followed by flux printing and mounting solder balls, or forming Sn, SnAg, Ni/Sn, Ni/SnAg, Ni/Cu/Sn, or Ni/Cu/SnAg using electroplating, followed by reflowing or followed by directly printing a solder paste thereon and reflowing. In an embodiment of the present invention, Ni/Pd/Au is formed using electroless printing, followed by flux printing, mounting solder balls and reflowing. Thus, solder joints 215 for bonding between the first wiring board and the FC-BGA board are formed to complete an assembly of the first wiring boards 212 in which the semiconductor elements 211 are fixed by first and second sealing resins.

Next, the assembly of the first wiring boards 212 after mounting the balls is cut into segments according to the shape of the support or wafer. Segmentation can be performed appropriately selecting a method from blade dicing, laser dicing, plasma dicing, and the like. In the present invention, segmentation is performed using blade dicing.

Next, as shown in Fig. 51, a segmented first wiring board 212 equipped with the semiconductor elements 211 is mounted to the FC-BGA board 213. The first wiring board 212 equipped with the semiconductor elements 211 is mounted to the FC-BGA board 213 by mounting and reflowing, TCB, or the like.

In the present embodiment, the first wiring board 212 equipped with the semiconductor elements 211 is mounted to the FC-BGA board 213, they are solder-bonded through mounting and reflowing processes, and a third sealing resin 218 is injected between the FC-BGA board 213 and the first wiring board 212 using capillary action. As a result, as shown in Fig. 52, a semiconductor device 220 according to the present invention can be obtained.

Some embodiments of the present invention have been exemplified so far; however, the present invention should not be construed as being limited to the above embodiments but can be additionally include other layers or structures for the purposes of improving other required physical properties such as rigidity, strength, and impact resistance, considering usage of the wiring board, as long as the technical ideas of the embodiments of the present invention is not departed from.

### <Advantageous Effects>

Next, advantageous effects of the structure of the above board unit and advantageous effects when the method of producing the board unit are used will be described.

According to an aspect of the present invention, in the method of forming a release layer and a fine wiring layer on a support, and mounting semiconductor elements thereon, followed by sealing and separation of the support substrate, for mounting to an FC-BGA board, warpage of the board unit can be suppressed, and the semiconductor elements can be mounted in a state of having no warpage.

The board unit, the method of producing the board unit, and the method of producing the semiconductor device according to the present embodiment are as follows.

[1] A board unit comprising
   a support; and
   at least one first wiring board disposed on the support via a release layer, wherein
   the at least one first wiring board has a first surface provided with electrodes to which at least one semiconductor element is bonded;
   the at least one first wiring board has a second surface provided with electrodes that are bonded to a second wiring board; and
   a warp-suppression layer is formed on a lower surface of the support.
[2] The board unit according to [1], wherein the warp-suppression layer is made of a resin.
[3] The board unit according to [1] or [2], wherein the warp-suppression layer has a thickness of 5 µm or more and 50 µm or less.
[4] The board unit according to any one of [1] to [3], wherein the warp-suppression layer contains a resin that is the same as an insulating resin of the at least one first wiring board.
[5] The board unit according to any one of [1] to [4], wherein the warp-suppression layer has a thickness that is smaller than that of the at least one first wiring board.
[6] The board unit according to any one of [1] to [3], wherein the warp-suppression layer contains a resin that is different from the insulating resin of the at least one first wiring board.
[7] The board unit according to any one of [1], [2], [3] and [6], wherein Young's modulus × thickness × CTE of the warp-suppression layer is 0.9 times to 1.1 times of Young's modulus × thickness × CTE of the insulating resin of the at least one first wiring board.
[8] The board unit according to any one of [1] to [7], wherein the support is made of glass.
[9] The board unit according to [3], wherein the warp-suppression layer contains a resin that is a mixture of one or more resins selected from epoxy resins, polyimide resins, polybenzoxazole resins, and benzocyclobutene resins.
[10] A method of producing a board unit including a support on which at least one first wiring board is disposed, comprising steps of:
   forming a release layer on an upper surface the support;
   forming a resin layer on the release layer;
   forming a warp-suppression layer on a lower surface of the support;
   forming openings in the resin layer;
   forming a seed layer extending across the resin layer and the openings;
   forming an electroplating layer on the seed layer;
   forming electrodes for bonding to a second wiring board by polishing the electroplating layer and the seed layer until the resin layer is exposed;
   forming multilayer wiring by repeating formation of a resin layer and a conductor layer on an upper surface of the exposed resin layer and the electrodes; and
   forming electrodes on an outermost surface of the multilayer wiring, for bonding to semiconductor elements.
[11] A method of producing a semiconductor device that uses the board unit according to any one of [1] to [9], comprising steps of:
   bonding the semiconductor elements to the at least one first wiring board;
   sealing gaps between the at least one first wiring board and the semiconductor elements with a first sealing resin;
   sealing side surfaces of the at least one first wiring board and the semiconductor elements with a second sealing resin;
   separating the at least one first wiring board from the support;
   obtaining an assembly in which the semiconductor elements are bonded to the at least one first wiring board;
   segmenting the assembly into units of the first wiring board;
   bonding the at least one first wiring board to the second wiring board; and
   sealing gaps between the at least one first wiring board and the second wiring board with a third sealing resin.
[12] The method of producing a semiconductor device according to [11], wherein
   the step of separating the at least one first wiring board from the support comprises a step of applying laser light to the warp-suppression layer.
[13] The method of producing a semiconductor device according to [12], wherein the laser light is IR laser light.

### Examples

### <Comparative experiments>

Table 2 shows comparative evaluation between presence and absence of the laser absorption layer 108 and the release layer 107 on the upper surface of the support 106, to confirm effects of the present embodiment. To evaluate separation of the laser absorption layer 108 and the release layer 107, copper was electroplated on the upper surface and then laser light was applied from the support 106 side, and separation was examined.

### (Examples 1-1 to 1-4)

### <Preparation of evaluation board>

Using a glass substrate (1.1 mm thickness) as a support 106, a polyimide resin was spin-coated on the upper surface of the support 106 to form a release layer 107 with a thickness of 500 nm. Ti was sputtered, as a laser absorption layer 108, on the upper surface of the release layer 107. Laser absorption layers 108 with thicknesses of 20 nm, 50 nm, 100 nm and 200 nm were formed as Examples 1 to 4. As a first seed layer 109, Cu: 300 nm was formed by sputtering on the upper surface of the laser absorption layer 108, and copper was electroplated thereon with a thickness of 20 µm. Then, a YAG laser (infrared laser) with a wavelength of 1,064 nm and a solid-state UV laser (ultraviolet laser) with a wavelength of 355 nm were applied to the board as prepared, and separation of the support 106 was evaluated.

### (Comparative Example 1-1)

As Comparative Example 1, an evaluation board without release layer 107 and laser absorption layer 108 (the remaining structure was similar to the examples) was prepared, and a YAG laser (infrared laser) with a wavelength of 1,064 nm and a solid-state UV laser (ultraviolet laser) with a wavelength of 355 nm were applied to the board, and separation of the support 106 was evaluated.

### (Comparative Example 1-2)

As Comparative Example 1-2, an evaluation board provided with a release layer 107 but not provided with a laser absorption layer 108 (the remaining structure was similar to the examples) was prepared, and a YAG laser (infrared laser) with a wavelength of 1,064 nm and a solid-state UV laser (ultraviolet laser) with a wavelength of 355 nm were applied to the board, and separation of the support 106 was evaluated.

**[Table 2]**

| | Layer structure | | | Evaluation of separation | |
|---|---|---|---|---|---|
| | Laser absorption layer | Thickness | Release layer | UV laser (Wavelength: 355 nm) | IR laser (Wavelength: 1,064 nm) |
| Ex. 1-1 | Present | 20 nm | Present | Good | Good |
| Ex. 1-2 | Present | 50 nm | Present | Good | Good |
| Ex. 1-3 | Present | 100 nm | Present | Good | Good |
| Ex. 1-4 | Present | 200 nm | Present | Fair | Fair |
| Comp. Ex. 1-1 | Absent | - | Absent | Poor | Poor |
| Comp. Ex. 1-2 | Absent | - | Present | Good | Poor |

In Examples 1-1 to 1-4, due to infrared laser irradiation, separation occurred at the interface between the release layer 107 and the laser absorption layer 108, and the support 106 became removable. The release layer 107 remained attached to the support 106, and no residues of the release layer 107 were observed on the laser absorption layer 108 on the board. However, in Comparative Examples 1-1 and 1-2, separation did not occur in spite of infrared laser irradiation.

In Examples 1-1 to 1-4, due to ultraviolet laser irradiation, separation occurred at the interface between the support 106 and the release layer 107, and the support 106 became removable. The release layer 107 remained attached to the laser absorption layer 108 on the board, and was observed as residues. In Comparative Example 1-2 also, the support 106 became removable due to ultraviolet laser irradiation; however, similarly to the examples, the release layer 107 was observed to remain attached to the board as residues. However, in Comparative Example 1-1, separation did not occur in spite of ultraviolet laser irradiation.

Let us consider the fact that separation occurred due to infrared laser irradiation only in Examples 1-1 to 1-4. Since the laser absorption layer 108 absorbs infrared laser, it is considered that heat generated by the absorption acted and caused separation at the interface between the release layer 107 and the laser absorption layer 108. Also, since the release layer 107 remains attached to the support 106, i.e., does not remain on the board, removal processing is not required to be performed. However, it is considered that, in Comparative Examples 1-1 and 1-2, separation did not occur due to the absence of the layer that absorbs infrared laser light.

Regarding the ultraviolet laser, separation occurred not only in the examples but also in Comparative Example 2. It is considered that, since the release layer 107 absorbs the ultraviolet laser, heat generated by the absorption acted in Comparative Example 2 and caused separation at the interface between the support 106 and the release layer 107. Also, in Comparative Example 2, since the release layer 107 remains attached to the board, the process thereafter requiring removal may become complicated. However, it is considered that, in Comparative Example 1, separation did not occur due to the absence of the layer that absorbs ultraviolet laser light.

Examples and comparative examples will be described below.

### (Example 2-1)

A laminate including a support, a light absorption layer, a release layer, a first seed layer, and a conductor layer was prepared through the following method.

First, a glass substrate having a thickness of 1.1 mm was prepared as a support. Next, a light absorption layer was formed on one surface of the support. The light absorption layer was formed by sputtering titanium on the support. The thickness of the light absorption layer was 20 nm.

Next, a release layer was formed on the light absorption layer. The release layer was formed by spin-coating a polyimide resin. As the polyimide resin, UPIA (trademark) manufactured by UBE Corporation was used. The thickness of the release layer was 500 nm.

Next, a first seed layer was formed on the release layer. Specifically, first, a first metal-containing layer of titanium was formed on the release layer by sputtering, and then a second metal-containing layer of copper was formed on the first metal-containing layer by electroplating. The first and second metal-containing layers had respective thicknesses of 50 nm and 300 nm.

Next, a copper layer was formed on the first seed layer by electroplating. The thickness of the copper layer was 20 µm.

In this way, a laminate was obtained.

### (Example 2-2)

A laminate was prepared as in Example 2-1 except that the thickness of the light absorption layer was changed from 20 nm to 50 nm.

### (Example 2-3)

A laminate was prepared as in Example 2-1 except that the thickness of the light absorption layer was changed from 20 nm to 100 nm.

### (Example 2-4)

A laminate was prepared as in Example 2-1 except that the thickness of the light absorption layer was changed from 20 nm to 200 nm.

### (Comparative Example 2-1)

A laminate was prepared as in Example 2-1 except that the light absorption layer was omitted.

### (Comparative Example 2-2)

A laminate was prepared as in Example 2-1 except that the light absorption layer and the release layer were omitted.

### (Comparative Example 2-3)

A laminate was prepared as in Example 2-1 except that the thickness of the light absorption layer was changed from 20 nm to 50 nm, and the release layer was omitted.

### (Evaluation)

To the laminates of Examples 2-1 to 2-4 and Comparative Examples 2-1 to 2-3, a solid-state UV laser with a wavelength of 355 nm and a YAG laser (IR laser) with a wavelength of 1,064 nm were applied from the support side. After that, separability of the support was examined. Table 3 shows the results. It should be noted that the solid-state UV laser was applied to the laminates so that the irradiation energy per unit area was 88.3 mJ/cm².

**[Table 3]**

| | Layer structure | | | Evaluation | |
|---|---|---|---|---|---|
| | Light absorption layer | Thickness of light absorption layer | Release layer | UV laser (Wavelength: 355 nm) | IR laser (Wavelength: 1,064 nm) |
| Ex. 2-1 | Present | 20 nm | Present | Good | Good |
| Ex. 2-2 | Present | 50 nm | Present | Good | Good |
| Ex. 2-3 | Present | 100 nm | Present | Good | Good |
| Ex. 2-4 | Present | 200 nm | Present | Fair | Fair |
| Comp. Ex. 2-1 | Absent | - | Present | Good | Poor |
| Comp. Ex. 2-2 | Absent | - | Absent | Poor | Poor |
| Comp. Ex. 2-3 | Present | 50 nm | Absent | Poor | Poor |

In the column of "UV laser" in Table 3, "Good" refers to the support becoming separable after one irradiation with an output of 0.06 W. "Fair" refers to the support not becoming separable after one irradiation with an output of 0.06 W, but becoming separable after two irradiations with an output of 0.06 W. "Poor" refers to the support not becoming separable even after three irradiations with an output of 0.06 W. In the column of "IR laser", "Good" refers to the support becoming separable after one irradiation with an output of 2.5 W. "Fair" refers to the support not becoming separable after one irradiation with an output of 2.5 W, but becoming separable after two irradiations with an output of 2.5 W. "Poor" refers to the support not becoming separable even after three irradiations with an output of 2.5 W.

As shown in Table 3, in the laminates of Examples 2-1 to 2-4, the support became separable in both of the cases of using UV laser and IR laser.

However, in the laminate of Comparative Example 2-1, although the support became separable when UV laser was used, it could not be separated when IR laser was used. As shown in Table 3, in the laminates of Examples 2-2 and 2-3, the support could not be separated in either of the cases of using UV laser and IR laser.

### <Comparative Example 3-1>

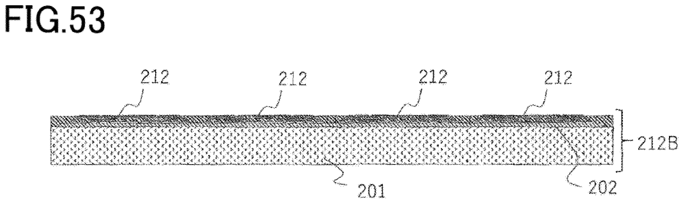

Referring to Fig. 53, a structure of a board unit produced without forming the warp-suppression layer 203 on the lower surface of the support will be described as a comparative example. Fig. 53 is a cross-sectional view illustrating a state in which a release layer 202 is formed on the upper surface of a support 201, and a plurality of first wiring boards 212 are formed on the upper surface of the release layer 202. No warp-suppression layer 203 is formed on the lower surface of the support 201.

Due to omission of the warp-suppression layer 203, warpage may occur in the board unit 212B. With the occurrence of warpage in the board unit 212B, mounting failure of the semiconductor elements may occur. High performance semiconductor elements of recent years have a large area, and mounting failures tend to occur in such semiconductor elements having a large area.

### <Examination of functions and effects>

To examine the effects of the present embodiment, simulation models of the board unit 12A of Example 3-1 and the board unit 212B of Comparative Example 3-1 were prepared. The size of the board unit was 300 mm square in both of Example 3-1 and Comparative Example 3-1. A material with Young's modulus of 1.5 GPa and CTE of 65 ppm was used as an insulating resin for the first wiring boards. The thickness of the insulating resin layer of each first wiring board was 17 µm in both of Example 3-1 and Comparative Example 3-1. In Example 3-1, a warp-suppression layer 3 of 15 µm was formed on the lower surface of the support using the same material as the insulating resin of the first wiring boards.

In the simulation model of Example 3-1, with the first wiring boards on top of the support, warpage with a downward deviation of 50 µm was calculated. In the simulation model of Comparative Example 3-1, with the first wiring boards on top of the support, warpage with a downward deviation of 400 µm was calculated. It was confirmed that formation of the warp-suppression layer 3 had an effect of reducing warpage.

The above embodiments are mere examples, and specific details may be modified as appropriate as a matter of course.

### [Reference Signs List]

- 101: First wiring board (interposer)
- 102, 122: Underfill
- 103: Second wiring board (FC-BGA board)
- 104: Semiconductor element
- 105: Sealing resin
- 106: Support
- 107: Release layer
- 108: Laser absorption layer
- 109: First seed layer
- 110: First resist pattern
- 113: Second seed layer
- 114: Second resist pattern
- 111, 115, 116: Conductor layer
- 112: Insulating resin layer
- 117: Outermost surface insulating resin layer
- 118: Surface treatment layer
- 119: Interposer-FC-BGA joint
- 119a: Interposer-side joint
- 119b: FC-BGA board-side joint
- 120: Laser light
- 121: Semiconductor element-interposer joint
- 123: Board unit with support
- 124: Board unit
- 125, 126: Semiconductor device
- 10: Wiring board with support
- 11: Support
- 12: Light absorption layer
- 13: Release layer
- 14: First seed layer
- 15: Wiring board
- 16: Outermost surface insulating layer
- 17: Surface treatment layer
- 18: First metal bump
- 20: First wiring board
- 21: Core layer
- 22: Conductor layer
- 23: Insulating resin
- 24: Layer
- 25: Electrode
- 26: Outermost surface insulating resin layer
- 27: Second metal bump
- 30: First joint
- 31: First underfill
- 40: Laser light
- 50: Functional device
- 51: Second joint
- 52: Second underfill
- 53: Sealing resin
- 60: Third metal bump
- 100: Composite wiring board
- 151A: Resist layer
- 151B: Resist layer
- 151C: Resist layer
- 152A: Conductor layer
- 152B: Conductor layer
- 152C: Conductor layer
- 152D: Conductor layer
- 153A: Insulating layer
- 153B: Insulating layer
- 153C: Insulating layer
- 154A: Second seed layer
- 154B: Second seed layer
- 154C: Second seed layer
- 200: Wiring board
- 241: Conductor pattern
- 242: Insulating layer
- 300: Packaged device
- 201: Support
- 202: Release layer
- 203: Warp-suppression layer
- 204: Insulating resin layer
- 205: Seed layer
- 206: Conductor layer
- 207: Resist pattern
- 208: Surface treatment layer
- 209: Electrode for mounting semiconductor element
- 210: Junction electrode to FC-BGA board
- 211: Semiconductor element
- 212: First wiring board
- 212A: Board unit of the present invention
- 212B: Board unit of comparative example
- 213: FC-BGA board (second wiring board)
- 214: Solder joint between semiconductor element and first wiring board
- 215: Solder joint between first wiring board and FC-BGA board
- 216: First sealing resin
- 217: Second sealing resin
- 218: Third sealing resin
- 219: Laser light
- 220: Semiconductor device

## Claims

1. A board unit with support comprising a support, a release layer, a laser absorption layer that absorbs laser light, and at least one first wiring board in this order, wherein
the at least one first wiring layer has a first surface provided with electrodes that can be bonded to at least one semiconductor element; and
the at least one first wiring layer has a second surface provided with second electrodes that can be bonded to a second wiring board.

2. The board unit with support according to claim 1, wherein the release layer transmits 50% or more of the laser light.

3. The board unit with support according to claim 1 or 2, wherein the laser light is infrared light.

4. The board unit with support according to any one of claims 1 to 3, wherein the laser absorption layer is disposed in an area inside the release layer in plan view.

5. The board unit with support according to any one of claims 1 to 4, wherein the laser absorption layer comprises a metal, and the release layer comprises an organic resin.

6. The board unit with support according to any one of claims 1 to 5, wherein the laser absorption layer is made of a material that is the same as a material of part of a seed layer as an upper layer.

7. A board unit produced using the board unit with support according to any one of claims 1 to 6, wherein
the at least one wiring board has a second surface to which the second wiring board is bonded;and
the support is absent due to removal by laser irradiation.

8. A method of producing a board unit with support, comprising steps of:
forming a release layer and a laser absorption layer in this order on an upper surface of a support;
forming a seed layer on the laser absorption layer;
forming electrodes on the seed layer using an electroplating layer;
obtaining multilayer wiring by repeating formation of a resin layer and a conductor layer on upper surfaces of the electrodes; and
preparing at least one first wiring board by forming electrodes on an uppermost surface of the multilayer wiring.

9. A method of forming a board unit comprising steps of:
bonding a board unit with support to a second wiring board, the board unit with support being prepared using the method of producing a board unit with support according to claim 8; and
separating the support by separating the release layer at an interface with the laser absorption layer using laser light irradiation.

10. A method of producing a semiconductor device comprising steps of:
bonding semiconductor elements to the board unit with support prepared using the method of producing a board unit with support according to claim 8; and
separating the support by separating the release layer at an interface with the laser absorption layer using laser light irradiation.
